(19) **Europäisches Patentamt**
**European Patent Office**
**Office européen des brevets**

(11) **EP 2 270 819 B1**

(12) **EUROPEAN PATENT SPECIFICATION**

(45) Date of publication and mention
of the grant of the patent:
**22.01.2014 Bulletin 2014/04**

(51) Int Cl.:
*H01B 5/14* *(2006.01)*  *C23C 14/08* *(2006.01)*
*H01B 13/00* *(2006.01)*  *C23C 14/58* *(2006.01)*

(21) Application number: **09725312.4**

(22) Date of filing: **05.03.2009**

(86) International application number:
**PCT/JP2009/054160**

(87) International publication number:
**WO 2009/119273 (01.10.2009 Gazette 2009/40)**

(54) **CONDUCTOR AND MANUFACTURING METHOD THEREFOR**

LEITER UND HERSTELLUNGSVERFAHREN DAFÜR

CONDUCTEUR ET SON PROCEDE DE FABRICATION

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(30) Priority: **25.03.2008 JP 2008078042**

(43) Date of publication of application:
**05.01.2011 Bulletin 2011/01**

(73) Proprietor: **Asahi Glass Company, Limited
Chiyoda-ku
Tokyo 100-8405 (JP)**

(72) Inventors:
  • **NAKAO, Shoichiro
Kawasaki-shi
Kanagawa 213-0012 (JP)**

• **YAMADA, Naoomi
Kawasaki-shi
Kanagawa 213-0012 (JP)**
• **HITOSUGI, Taro
Kawasaki-shi
Kanagawa 213-0012 (JP)**
• **HASEGAWA, Tetsuya
Kawasaki-shi
Kanagawa 213-0012 (JP)**

(74) Representative: **Müller-Boré & Partner
Patentanwälte PartG mbB
Grafinger Straße 2
81671 München (DE)**

(56) References cited:
**WO-A1-2006/073189    WO-A1-2009/057606
JP-A- 55 050 221    JP-A- 2002 212 463
JP-A- 2005 011 737    JP-A- 2006 152 391
JP-A- 2007 329 109    JP-A- 2008 084 824**

EP 2 270 819 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The present invention relates to an electric conductor and a process for its production.

BACKGROUND ART

In recent years, large-sized liquid crystal display panels and small-sized liquid crystal display panels for portable devices are increasingly demanded. In order to realize these, low power consumption of display elements is required, and application of transparent electrodes having high visible light transmittance and low resistance, is essential.

In particular, organic electroluminescence elements that are being developed recently, are self-emission type elements effectively applicable to small-sized portable devices, but they have a problem that they consume large power since they use a current-drive method. Further, plasma display panels (PDP) being widely spread in the market and field emission displays (FED) being developed as the next generation display, have a problem that they have a structure of high power consumption. From these reasons, low-resistance transparent electrically conductive thin films are highly desired.

A typical example of transparent electrically conductive thin film is an indium tin oxide film (hereinafter referred to as ITO film) made of indium oxide doped with tin.

An ITO film is excellent in transparency and has high electric conductivity, but it has a demerit that since the earth crust contains only 50 ppb of In, the raw material cost increases as In resource is exhausted.

In recent years, as a material of transparent electric conductor, titanium dioxide ($TiO_2$) having both chemical resistance and durability has attracted attention (for example Non-Patent Document 1).

The following Patent Document 1 proposes a method of obtaining a transparent conductor by forming on a substrate a metal oxide layer of $M:TiO_2$ (M is e.g. Nb or Ta) having an anatase crystal structure. This document shows that a single crystal thin film (solid solution) of $M:TiO_2$ having an anatase crystal structure formed by epitaxial growth, significantly increases electric conductivity while it maintains transparency.

The following Patent Document 2 proposes a method of obtaining a transparent electrically conductive thin film laminate by forming on a transparent substrate body a laminate in which a transparent high-refractive-index thin film layer containing hydrogen and a metal thin film layer are alternately laminated. The transparent high-refractive-index thin film layer is made of e.g. titanium oxide.

None of these documents discloses annealing after forming a metal oxide layer.

Non-Patent Document 1: Oyo Butsuri (Applied Physics) Vol. 73, No. 5 (2004), p. 587-592
Patent Document 1: WO2006/016608
Patent Document 2: JP-A-2004-95240

DISCLOSURE OF THE INVENTION

OBJECT TO BE ACCOMPLISHED BY THE INVENTION

The single crystal thin film of $M:TiO_2$ having an anatase crystal structure described in Patent Document 1, is difficult to produce and is not likely to be practically used as the productivity is not good.

The transparent refractive index thin film layer in Patent Document 2 tends to have insufficient transparency since it contains hydrogen at a time of forming the film.

Thus, it has been difficult to realize an electric conductor having low electric resistance and being excellent in transparency.

Further, depending upon the particular application of the electric conductor, excellent heat resistance is required to such an extent that its electric conductivity will not deteriorate even when heated at 300°C or higher in the atmosphere.

The present invention has been made considering the above-mentioned circumstances, and it is an object of the present invention to provide an electric conductor having good electric conductivity and transparency and is excellent in heat resistance, and a process for its production.

MEANS TO ACCOMPLISH THE OBJECT

In order to accomplish the above object, the present inventors have developed a method of forming a transparent electrically conductive film by forming a layer made of titanium oxide doped with a dopant such as Nb, followed by annealing in a reducing atmosphere, and have already filed patent applications (JP-A-2008-084824, US Patent Application Publication No. 2007/0218646, US Patent Application Serial No. 11/688,013).

And, as a result of an extensive research on the heat resistance of the electrically conductive film obtainable by this method, it has been found that as shown by Examples given hereinafter, the film has a characteristic such that its heat resistance is remarkably improved when the dopant concentration in the electrically conductive film is within a specific range. Further, they have found a process whereby a transparent electrically conductive film can be formed by carrying out an annealing step in the atmosphere, based on such a characteristic, and thus have accomplished the present invention.

That is, the electric conductor of the present invention comprises a substrate and at least two layers formed on the substrate, each being a layer (Z) made of titanium oxide doped with at least one dopant selected from the group consisting of Nb, Ta, Mo, As, Sb, W, N, F, S, Se, Te, Cr, Ni, Tc, Re, P and Bi, wherein:

at least one layer among said at least two layers is a second layer (Z2) wherein the percentage of the number of dopant atoms based on the total number of titanium and dopant atoms is from 0.01 to 4 atomic%; and
between the second layer (Z2) and the substrate, a first layer (Z1) is formed wherein the percentage of the number of dopant atoms based on the total number of titanium and dopant atoms is larger than in the second layer (Z2).

In the first layer (Z1), the percentage of the number of dopant atoms based on the total number of titanium and dopant atoms is preferably from 2 to 7 atomic%.

The second layer (Z2) preferably has a thickness of at least 3 nm.

The substrate is preferably made of glass.

The process for producing an electric conductor of the present invention comprises:

a precursor layer-forming step of forming on a substrate a precursor layer made of titanium oxide doped with at least one dopant selected from the group consisting of Nb, Ta, Mo, As, Sb, W, N, F, S, Se, Te, Cr, Ni, Tc, Re, P and Bi, wherein the percentage of the number of dopant atoms based on the total number of titanium and dopant atoms is from 0.01 to 4 atomic%; and
an atmospheric annealing step of heat-treating the precursor layer in the atmosphere in a temperature range of at least the crystallization temperature and lower than the electric conductivity-deteriorating temperature of the precursor layer.

Further, the present invention provides a process for producing an electric conductor, which comprises:

a precursor layer-forming step of forming on a substrate at least two precursor layers each being a layer made of titanium oxide doped with at least one dopant selected from the group consisting of Nb, Ta, Mo, As, Sb, W, N, F, S, Se, Te, Cr, Ni, Tc, Re, P and Bi; and
an atmospheric annealing step of heat-treating the precursor layers in the atmosphere; wherein:

at least one layer among said at least two precursor layers is a second precursor layer wherein the percentage of the number of dopant atoms based on the total number of titanium and dopant atoms is from 0.01 to 4 atomic%;
between the second precursor layer and the substrate, a first precursor layer is present wherein the percentage of the number of dopant atoms based on the total number of titanium and dopant atoms is larger than in the second dopant layer; and
the heat-treating temperature in the atmospheric annealing step is at least the highest temperature among the respective crystallization temperatures of the precursor layers formed on the substrate and lower than the electric conductivity-deteriorating temperature of the second precursor layer.

It is preferred that at least one layer among said at least two precursor layers, when subjected to a single layer annealing test, becomes a layer containing polycrystals which contain no rutile crystals.

Forming of the precursor layer(s) is preferably carried out by a pulsed laser deposition method or a sputtering method.

The substrate to be used in the process for producing an electric conductor of the present invention is preferably made of glass.

ADVANTAGEOUS EFFECTS OF THE INVENTION

According to the present invention, it is possible to obtain an electric conductor having good electric conductivity and transparency and being excellent in heat resistance.

Further, according to the present invention, it is possible to produce an electric conductor having good electric conductivity and transparency and being excellent in  heat resistance, by a process wherein an annealing step is carried out in the atmosphere.

BRIEF DESCRIPTION OF THE DRAWINGS

Fig. 1 is a cross-sectional view illustrating an example of the electric conductor according to the present invention.
Fig. 2 is a cross-sectional view illustrating an example of the electric conductor according to the present invention.
Fig. 3 is views illustrating an example wherein a precursor laminate is formed by a sputtering method.
Fig. 4 is a cross-sectional view illustrating an example of the electric conductor according to the present invention.
Fig. 5 is a graph illustrating the relation between the substrate temperature and the specific resistance when an amorphous layer is crystallized.
Fig. 6 is a graph illustrating the relation between the absolute value of first derivation ($d\rho/dT$) of the specific resistance and the substrate temperature T in Fig. 5.
Fig. 7 is a graph illustrating the relation between the Nb content, and the crystallization temperature Tcr and electric conductivity-deteriorating temperature Td.

Fig. 8 is a graph illustrating the relation between the substrate temperature and the specific resistance when a polycrystallized electric conductor film is heated in the atmosphere.

Fig. 9 is a graph illustrating the relation between the first derivation (dp/dT) of the specific resistance p and the substrate temperature T in Fig. 8.

Fig. 10 is a graph illustrating the relation between the substrate temperature and the specific resistance when a film after annealing is heated in the atmosphere.

Fig. 11 is a graph illustrating the relation between the specific resistance of a film after annealing and the Nb content in the film.

Fig. 12 is a graph illustrating the light absorption characteristics of the film after annealing.

Fig. 13 is a graph illustrating the relation between the substrate temperature and the specific resistance when a film after annealing is heated in the atmosphere with respect to a case where a protective layer is formed and a case where no protective layer is formed.

Fig. 14 is a graph illustrating the light absorption characteristics of a film annealed with a protective layer provided.

Fig. 15 is a graph illustrating the relation between the substrate temperature during the annealing step and the specific resistance of the sample film, when annealed with a protective layer provided.

MEANINGS OF SYMBOLS

10:     Substrate
11:     Main layer (first layer)
11a:    Seed layer
11b:    Interlayer
12:     Protective layer (second layer)
32:     Electric conductor layer

BEST MODE FOR CARRYING OUT THE INVENTION

Now, embodiments of the present invention will be described in detail.

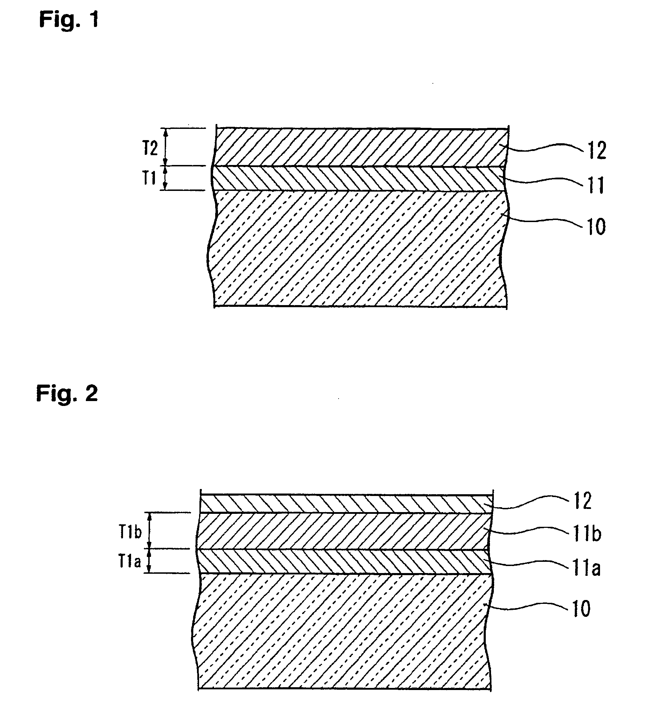

Fig. 1 is a cross-sectional view illustrating a first embodiment of the electric conductor of the present invention. In the electric conductor of this embodiment, a first layer (Z1) 11 made of titanium oxide doped with a dopant, is formed on a substrate 10, and a second layer (Z2) 12 made of titanium oxide doped with a dopant, is formed thereon.

In this embodiment, the first layer 11 is a layer which plays a main role of electric conductivity and will hereinafter be referred to as the main layer. The second layer 12 is a layer having heat resistance, and such a second layer will be referred to as a protective layer.

Fig. 2 is a cross-sectional view illustrating a second embodiment of the electric conductor of the present invention. The electric conductor of this embodiment is different from the above first embodiment in that the portion corresponding to the main layer 11 is composed of a seed layer 11 a formed on the substrate 10 and an interlayer 11b formed thereon. The protective layer 12 is formed on the interlayer 11b. The interlayer 11 b corresponds to the first layer (Z1) in the present invention.

[SUBSTRATE]

The material of the substrate 10 is not particularly limited. It may, for example, be a single crystal material, a polycrystal material, an amorphous material, or a material wherein such crystal states are mixed.

The substrate 10 is preferably transparent. In this specification, "transparent" means that the transmittance is at least 50% to light in a visible light region with a wavelength of from 400 to 700 nm.

Specific examples of the substrate (10) include a substrate made of single crystal or polycrystal strontium titanate ($SrTiO_3$); a single crystal substrate or a polycrystal substrate made of a rock salt type crystal of perovskite crystal structure or a similar structure; a substrate made of single crystal or polycrystal gallium nitride; a single crystal substrate or a polycrystal substrate made of a nitride or an oxide of a zinc blende crystal of wurtzite crystal structure or a similar structure; a quartz substrate; a glass substrate made of a glass material such as non-alkali glass (for example, AN 100, model name, manufactured by Asahi Glass Company, Limited or 1737) or soda lime glass; a plastic substrate made of a plastic material such as a polyimide, a polyethylene terephthalate, a polyethylene naphthalate, triacetylacetonate, a polyethersulfone, a polycarbonate, a polyethylene, a polyvinyl chloride, a polypropylene or a polymethacrylate; and a semiconductor substrate such as a silicon substrate (thermally oxidized Si substrate) on a surface of which a thermally oxidized film is formed. The substrate 10 may contain a dopant or an impurity within a range not impairing effects of the present invention.

In a case of employing a single crystal substrate of $SrTiO_3$ as the substrate 10, the substrate is preferably one finished so that the substrate surface corresponds to the (100) plane.

Particularly preferred is a glass substrate, since one which is transparent and has a smooth surface is readily obtainable, and it is inexpensive and provided with practically required various durabilities. The shape of the substrate 10 is not particularly limited. For example, it may be a plate-shape or a film shape such as a plastic film.

The thickness of the substrate 10 is not particularly limited. In a case where  the transparency of the substrate 10 is required, the thickness is preferably at most 1 mm. In a case of a plate-shaped substrate 10 where a mechanical strength is required and the transmittance may be sacrificed to a certain extent, the thickness may be more than 1 mm. The thickness of the substrate 10 is preferably, for example, from 0.2 to 1 mm.

As the substrate 10, a polished substrate may be employed as the case requires. A substrate having crystallinity such as a $SrTiO_3$ substrate, is preferably polished for use. For example, such a substrate is mechanically polished by using a diamond slurry as an abrasive. In such a mechanical polishing, it is preferred to gradually reduce the grain size of the diamond slurry to be used, and to carry out mirror polishing with a diamond slurry having a grain size of about 0.5 $\mu$m in the final step. Thereafter, a further polishing with a colloidal silica may be carried out to obtain a surface roughness of 10 Å (1 nm) or less in terms of root mean square (rms) roughness.

The substrate 10 may be preliminarily processed. This preliminary process may, for example, be carried out by the following procedure. First of all, the substrate is cleaned with e.g. acetone or ethanol. Then, the substrate is immersed in high-purity hydrochloric acid (for example, EL grade, concentration: 36 mass%, manufactured by Kanto Chemical Co., Ltd.) for 2 minutes. Then, the substrate is moved into purified water to wash out e.g. the hydrochloric acid. Then, the substrate is moved into new purified water and subjected to ultrasonic cleaning for 5 minutes. Subsequently, the substrate is taken out from the purified water, and nitrogen gas is blown against its surface to remove water from the substrate surface. These treatments are carried out, for example, at room temperature. By these treatments, e.g. oxides and organic substances are considered to be removed from the substrate surface. In the above example, hydrochloric acid is used, but instead of this, an acid such as nitrohydrochloric acid or hydrofluoric acid may be used. The treatment with the acid may be carried out at room temperature or a heated acid may be used.

[DOPANT]

Each of the main layer 11, the protective layer 12, the seed layer 11 a and the interlayer 11 b is made of titanium oxide doped with at least one dopant selected from the group consisting of Nb, Ta, Mo, As, Sb, W, N, F, S, Se, Te, Cr, Ni, Tc, Re, P and Bi.

The titanium oxide of the present invention is one in which Ti sites of $TiO_2$ are substituted by metal atoms M (dopant), and in this specification, it may be referred to as "$M:TiO_2$". In the present specification, "titanium oxide" and "$TiO_2$" include "$TiO_{2-\delta}$" ($\delta$ is the oxygen deficiency amount) unless otherwise specified.

In the main layer 11, the protective layer 12, the seed layer 11 a and the interlayer 11 b, the content of impurities other than the dopant metal atoms (M), oxygen atoms (O) and titanium atoms (Ti) is preferably at most 0.1 atomic%.

Particularly, when Nb, Ta, Mo, As, Sb or W is employed as a dopant, improvement of electric conductivity is expected while transparency is maintained. Further, when Cr, Ni, Tc, Re, P or Bi is employed as a dopant, magneto-optics effects or ferromagnetism is expected.

Among the above-mentioned dopants, it is preferred to employ Nb, Ta, Mo, As, Sb or W, and particularly, it is preferred to employ Nb and/or Ta in terms of improving electric conductivity.

In the first embodiment, the dopant added in the main layer 11 and the dopant added in the protective layer 12 may be the same or different.

In the second embodiment, the dopant added in the seed layer 11 a, the dopant added in the interlayer 11 b and the dopant added in the protective layer 12, may be the same or different.

[MAIN LAYER]

The content of the dopant in the main layer 11 is preferably at least 2 atomic% and at most 7 atomic%, provided that the total amount of titanium atoms (Ti) and dopant metal atoms (M) in the layer is 100 atomic% (the same applies hereinafter). When it is at least 2 atomic%, high transparency and low resistance can easily be obtained simultaneously. If it exceeds 7 atomic%, the transparency and electric conductivity are likely to deteriorate. A more preferred range is from 3 to 6 atomic%.

The thickness T1 of the main layer 11 is not particularly limited and may be set to be a desired thickness depending upon the particular application, etc. For example, it is preferably from 20 to 1,000 nm, more preferably from 100 to 200 nm.

[SEED LAYER AND INTERLAYER]

A preferred range of the dopant content in the seed layer 11 a and in the interlayer 11b is the same as in the main layer. The dopant contents in the seed layer 11 a and in the interlayer 11 b may be the same or different.

The thickness T1a of the seed layer 11 a is preferably at least 5 nm and at most 50 nm, more preferably at least 10 nm and at most 40 nm. When the thickness is within such a range, an electric conductor having a low electric resistance and excellent transparency can easily be obtained.

The thickness T1 b of the interlayer 11b is not particularly limited and may be set to be a desired thickness depending upon the particular application, etc. For example, the total in thickness (T1a+T1b) of the seed layer 11a and the interlayer 11b is preferably from 20 to 1,000 nm, more preferably from 100 to 200 nm.

[PROTECTIVE LAYER]

The content of the dopant in the protective layer 12 is at least 0.01 atomic% and at most 4 atomic%. When it is at least 0.01 atomic%, electric conductivity is obtainable in the protective layer 12. When it is at most 4 atomic%, good heat resistance can be obtained. A more preferred range is from 0.01 to 3 atomic%, and from 0.5 to 1.5 atomic% is further preferred.

The thickness T2 of the protective layer 12 is preferably at least 3 nm. When it is at least 3 nm, good heat resistance can be obtained. It is more preferably at least 10 nm. The upper limit is not particularly limited, but if it is too thick, the transparency tends to deteriorate, and the time for its production tends to be long. The thickness is preferably at most 100 nm, more preferably at most 70 nm.

Between the protective layer 12 and the substrate 10, a layer having a dopant content larger than in the protective layer 12 is present. Particularly, the dopant amount in the layer having a main role of electric conductivity is preferably larger than the dopant content in the protective layer 12. The main layer 11 and the interlayer 11 b in this embodiment preferably have a dopant content larger than in the protective layer 12.

In each of the sputtering method and the pulsed laser deposition (PLD) method, the dopant composition in the film will be substantially equal to the dopant composition in a target to be used for the film formation.

Accordingly, the dopant content in the film can be controlled by the dopant content in the target to be used for the film formation.

<FIRST PRODUCTION PROCESS>

The electric conductor of the present invention can suitably be produced by using the process for producing an electric conductor of the present invention (first production process).

In order to produce the electric conductor of the first embodiment, firstly, a precursor layer (first precursor layer) for the main layer 11 is formed on a substrate 10, and a precursor layer (second precursor layer) for the protective layer 12 is formed thereon (precursor layer-forming step). Then, these precursor layers are heat-treated in the atmosphere (atmospheric annealing step).

In order to produce the electric conductor in the second embodiment, firstly, a precursor layer for the seed layer 11 a is formed on a substrate 10, a precursor layer (first precursor layer) for the interlayer 11 b is formed thereon, and a precursor layer (second precursor layer) for the protective layer 12 is formed thereon (precursor layer-forming step). And, these precursor layers are heat-treated in the atmosphere (atmospheric annealing step).

[PRECURSOR LAYER]

The content of the dopant in a precursor layer will be maintained even after annealing. Therefore, the content of the dopant in a precursor layer is set to be the same dopant content in a layer to be obtained after annealing.

The nature of the precursor layer is influential over the crystal state after annealing. Therefore, the nature of the precursor layer is set, so that a desired crystal state can be obtained after annealing.

In the atmospheric annealing step, the precursor layer is heated at a temperature of at least the crystallization temperature of the precursor layer. Therefore, when the crystal state of the precursor layer is amorphous, it will be polycrystallized by annealing. To accomplish a low resistance, crystals constituting the polycrystal layer after annealing are preferably anatase-type and preferably contain no rutile crystals. The crystal state after annealing can be controlled by the oxygen content in the amorphous layer (precursor layer) before annealing.

In a case where polycrystals are present in a precursor layer, if crystals constituting the polycrystals are anatase-type, the polycrystals after annealing will be anatase-type. If rutile-type is contained in polycrystals in the precursor layer, the polycrystals after annealing will contain rutile-type.

The crystal state in the precursor layer can be confirmed by an XRD profile. That is, the XRD profile is measured by an X-ray diffraction (XRD) apparatus, whereby the presence or absence of (101) and (004) peaks which are observed characteristically in anatase polycrystals and a (110) peak which is observed characteristically in rutile polycrystals, is determined. In a case where no peak is observed, such a layer is judged to be an amorphous layer, and when any one of the peaks is observed, it is judged to be a layer containing polycrystals. Further, when the (110) peak is observed, such polycrystals are judged to contain rutile-type, and when no (110) peak is observed, such polycrystals are judged to contain no rutile-type.

[PRECURSOR LAYER FOR MAIN LAYER]

The precursor layer for the main layer 11 may become a transparent electric conductive film after annealing. In order to lower the electric resistance of the main layer 11, the precursor layer is preferably an amorphous layer or a layer which contains polycrystals, but such polycrystals contain no rutile crystal. It is more preferred to satisfy conditions (Y1) and/or (Y2) which will be described later.

[PRECURSOR LAYER FOR PROTECTIVE LAYER]

The precursor layer for the protective layer 12 may become a transparent electric conductive film after annealing. Such a precursor layer is preferably an amorphous layer or a layer which contain polycrystals, but such polycrystals contain no rutile crystals. In order to accomplish a lower resistance, it is preferably an amorphous layer. It is preferred to control the oxygen content in the precursor layer, so that the electric resistance of the protective layer 12 becomes low.

[PRECURSOR LAYER FOR SEED LAYER OR INTERLAYER]

The precursor layer for a seed layer 11 a is formed to satisfy at least one of the following conditions (X1) and (X2). It may satisfy both conditions simultaneously.

(X1) When subjected to a single layer annealing test, it becomes a layer containing polycrystals which contain no rutile crystals.
(X2) The absorption coefficient at a wavelength of 800 nm is more than 0 cm$^{-1}$ and less than $2\times10^4$ cm$^{-1}$.

The precursor layer for the interlayer 11b may be an amorphous layer, but it preferably further satisfies at least one of the following conditions (Y1) and (Y2) in order to obtain a low resistance electric conductor. It may satisfy both conditions simultaneously.

(Y1) When subjected to a single layer annealing test by the following method, it becomes a layer containing polycrystals which contain rutile crystals.
(Y2) The absorption coefficient at a wavelength of 800 nm is more than $2\times10^4$ cm$^{-1}$ and less than $5\times10^4$ cm$^{-1}$.

[SINGLE LAYER ANNEALING TEST]

The single layer annealing test on the precursor layer for the sheet layer 11a or the interlayer 11b is carried out by the following procedure by using a sample film formed in a thickness of 100 nm on a non-alkali glass substrate.

Firstly, on the surface of a substrate made of non-alkali glass (model name: AN100, manufactured by Asahi Glass Company, Limited), a sample film is formed by using a target with the same composition and the same film forming conditions as those used at the time of forming a precursor layer for a seed layer 11 a or interlayer 11b on a substrate in a practical process. Here, the thickness of the sample film is 100 nm irrespective of the thickness of the practical precursor layer.

Then, such a sample film is subjected to a single layer annealing test. That is, the annealing atmosphere is once vacuumed to 10$^{-1}$ Pa, and then, hydrogen (H$_2$) is introduced to form a 100% H$_2$ atmosphere. The atmospheric pressure at that time is $1.013\times10^5$ Pa (1 atm). Then, in such a H$_2$ atmosphere, a heated body is contacted to the rear surface of a substrate for heating so that the substrate temperature reaches from room temperature (about 25°C) to 500°C in 5 minutes. And after maintained at 500°C for one hour, the temperature is left to cool to room temperature.

With respect to the sample film thus subjected to a single layer annealing test, the XRD profile is measured by an X-ray diffraction (XRD) apparatus, and judgment is made in the same manner as in the above-described method for judging the crystal state in the precursor layer.

[ABSORPTION COEFFICIENT]

In the present invention, the value of "the absorption coefficient at a wavelength of 800 nm" is a value obtained by the following method.

Firstly, the transmittance and the reflectance at a wavelength of 800 nm are measured. When the measured value of the transmittance is T (%), the measured value of the reflectance is R (%) and the film thickness is d (nm), the absorption coefficient $\alpha$ is calculated by the following formula (1).

$$A=[\ln\{(100-R)/T\}]/d\times10^7 \quad (1)$$

With respect to the conditions of the above (X1), the heating temperature in the single layer annealing test is 500°C, whereby even if the sample film before annealing is amorphous, the sample film after annealing contains polycrystals. When the film forming conditions for the precursor layer are made to be such conditions that the oxygen content in the film becomes small, the film after the single layer annealing test tends to contain rutile crystals.

In a case where the film before annealing contains polycrystals, and such polycrystals contain no rutile crystals, the polycrystals in the sample film after annealing contain no rutile crystals.

With respect to the conditions of the above (X2), when the film forming conditions are made to be such conditions that the oxygen content in the film becomes small, the absorption coefficient at a wavelength of 800 nm tends to be large.

In a case where the precursor layer is an amorphous layer formed to satisfy the conditions of the above (X2), when such an amorphous layer is heated at a temperature of at least the crystallization temperature, anatase crystals are likely to be formed, and rutile crystals tend to be hardly formed.

With respect to the conditions (Y1) and (Y2) for the interlayer 11 b, it is possible to obtain a precursor layer made of an amorphous layer satisfying the above (Y1) and/or (Y2) by adjusting the film forming conditions for the precursor layer for the interlayer 11 b to be such a condition that an amorphous film can be obtained, and the oxygen content in the film becomes large.

The precursor for the interlayer 11 b is formed to satisfy the condition of the above (Y1), and accordingly, when it is annealed in a single layer, it becomes polycrystals containing rutile crystals, but when annealing is carried out in a state where the interlayer 11 b is laminated on the seed layer 11 a, formation of rutile crystals is suppressed to a large extent. Particularly when heating is carried out from the substrate 10 side during the annealing, the product will be polycrystals containing no rutile crystals. This is a surprising phenomenon.

And, as compared with the electric conductive layer composed solely of the main layer 11, the electric conductive layer composed of the seed layer 11 a and the interlayer 11 b, has a small specific resistance and has the carrier concentration and hall mobility remarkably improved, although they are the same in that they are polycrystals containing no rutile crystals.

Each precursor layer can be formed by appropriately using a known film forming method. Specifically, a physical vapor deposition (PVD) method such as a pulsed laser deposition (PLD) method or a sputtering method; a chemical vapor deposition (CVD) method such as a MOCVD method; or a film forming method by a synthesizing process from a solution such as a sol gel method or a chemical solution method, may, for example, be mentioned.

Particularly, a PLD method is preferred since good film conditions can thereby be easily obtained, and a sputtering method is preferred since film forming is thereby easy irrespective of the crystallinity of the substrate.

[SPUTTERING METHOD]

In the case of the sputtering method, it is preferred to form a precursor layer by a reactive sputtering method in an atmospheric gas containing an oxidizing sputtering gas. As a sputtering apparatus, a known apparatus can be appropriately used. For example, a reactive DC magnetron sputtering apparatus can be used.

Specifically, a target and a substrate 10 are firstly set in a vacuum chamber of the sputtering apparatus. The vacuum chamber is evacuated by a pump to be in a vacuum state, and then a sputtering gas is introduced to adjust the sputtering pressure to a predetermined level.

Then, while the sputtering pressure is maintained, a magnetic field with a predetermined strength is generated by a magnet provided on the rear surface of the target, and a predetermined voltage is applied to the target to form a precursor layer on the substrate.

The sputtering pressure during the film forming is, for example, preferably at a level of from 0.1 to 5.0 Pa, more preferably at a level of from 0.3 to 3.0 Pa.

(TARGET)

The target to be used for the film forming by the sputtering method, may be a metal target or a metal oxide target, or both of them may be used in combination. The metal target may, for example, be a titanium alloy doped with a predetermined amount of a dopant. The metal oxide target may, for example, be a $TiO_2$ sintered body doped with a predetermined amount of a dopant. For example, a $Nb:TiO_2$ sintered body can be prepared by mixing powders of $TiO_2$ and $Nb_2O_5$ weighed to have a desired atomic ratio and heat-molding the mixed powder. One type of a target may be doped with a plurality of dopants.

The content of the dopant in the target is substantially equal to the content of the dopant in the film formed by using the target. Accordingly, it is preferred to set the dopant content in the target depending on the desired dopant content in the precursor layer to be obtained.

In the composition of the metal oxide target, the ratio of the atomicity of 0 to the atomicity of Ti (O/Ti ratio) is preferably within a range of from 0.5 to 2.0. That is, in $M:TiO_{2-\delta}$, $\delta$ is preferably $0 \leq \delta \leq 1.5$. If the O/Ti ratio is lower than this range, the film is likely to be colored, and it is difficult to satisfy both high transparency and high electric conductivity. An oxide having an O/Ti ratio higher than this range, is difficult to prepare. When the O/Ti ratio is within a range of from 1.0 to 2.0, the transparency and electric conductivity of the film can easily be satisfied simultaneously. Further, when the O/Ti ratio is within a range of from 1.5 to 2.0, a film having higher transparency will be obtained.

The crystal structure of the metal oxide target may be any of rutile type, anatase type, brookite type and Magneli phase, or may be a mixture thereof.

(SPUTTERING GAS)

As the sputtering gas, at least an oxidizing sputtering gas is used, and preferably, a mixed gas of an oxidizing sputtering gas and an inert gas is used. As the inert gas, one or at least two selected from the group consisting of Ar, He, Ne, Kr and Xe may be used. As the oxidizing sputtering gas, one or at least two selected from the group consisting of $O_2$, $O_3$, $H_2O$ and $CO_2$ may be used. In view of the safety and maintenance of a film formation apparatus, it is preferred to use $O_2$ as the oxidizing sputtering gas.

The concentration of the oxidizing sputtering gas in the atmospheric gas at the time of film formation may be adjusted by the ratio of the flow rate of the oxidizing sputtering gas to the total flow rate of sputtering gases introduced to the vacuum chamber (hereinafter sometimes referred to as the oxidizing sputtering gas flow ratio). For example, in a case where a mixed gas of an oxidizing sputtering gas and an inert gas is used as the sputtering gas, the total flow rate of sputtering gases is the total amount of the flow rate of the oxidizing sputtering gas and the flow rate of the inert gas.

(SUBSTRATE TEMPERATURE: SEED LAYER)

The precursor layer for the seed layer 11 a is formed so that it becomes an amorphous layer or a layer containing polycrystals which contain no rutile crystals. For this purpose, the substrate temperature at the time of forming the precursor layer is preferably at most 600°C.

If it exceeds 600°C, rutile crystals are likely to be formed. The lower limit value of the substrate temperature during the film formation is not particularly limited so long as it is a temperature at which film formation is possible. For example, the substrate temperature is preferably at least 77K (about -196°C). In order to accomplish a lower resistance, the precursor layer for the seed layer 11 a is preferably an amorphous layer, and for this purpose, the substrate temperature during the film formation is preferably at most room temperature. In this specification, "room temperature" for the substrate temperature during the film formation is the temperature range which the substrate temperature can take at the time of film formation without heating the substrate, and it is at a level of from 25 to 80°C in the case of the sputtering method. Accordingly, in order to make the precursor layer for the seed layer 11 a to be amorphous, it is preferred to carry out the film formation in a state where the substrate is not heated. More specifically, it is preferred that the substrate temperature during the film formation is kept at a level of, for example, from 25 to 50°C, and it is preferred to cool the substrate as the case requires.

In a case where the precursor layer for the seed layer 11 a is a layer containing polycrystals, it is acceptable so long as the polycrystals after annealing do not contain rutile type. Accordingly, a layer containing polycrystals prepared by forming an amorphous layer, for example, at a substrate temperature of at most room temperature and annealing (hereinafter referred to as intermediate annealing) the amorphous layer at a temperature of at least the crystallization temperature so that no rutile crystals will be formed, may also be used as the precursor layer for the seed layer 11 a.

(SUBSTRATE TEMPERATURE: INTERLAYER)

The precursor layer for the interlayer 11 b is formed so that it becomes an amorphous layer. For this purpose, the substrate temperature at the time of forming the precursor layer is preferably at most room temperature. That is, the precursor layer for the interlayer 11 b is preferably formed in a state where the substrate is not heated. Specifically, it is preferred that the substrate temperature during the film formation is maintained, for example, at a level of from 25 to 50°C, and if necessary, it is preferred to cool the substrate. The lower limit value for the substrate temperature during the film formation is not particularly limited so long as it is a temperature at which the film formation is possible.

For example, the substrate temperature is preferably at least 77 K (about - 196°C).

(SUBSTRATE TEMPERATURE: MAIN LAYER AND PROTECTIVE LAYER)

The precursor layer for the main layer 11 or the protective layer 12 is formed so that it becomes an amorphous layer or a layer containing polycrystals which contain no rutile crystals. The substrate temperature is the same as the substrate temperature at the time of forming the precursor layer for the seed layer 11 a, including a preferred embodiment.

The oxygen content in the film can be controlled by the production conditions for the film formation. For example, in the case of a sputtering method, there are (A) a method of controlling the concentration of the oxidative sputtering gas in the atmospheric gas during the film forming, and (B) a method of controlling the content of oxygen atoms in the target to be used for the film formation.

The methods (A) and (B) may be used in combination.

(A) OXIDIZING SPUTTERING GAS FLOW RATIO

The concentration of oxidizing sputtering gas in the atmospheric gas at the time of forming the precursor layer can specifically be controlled by the oxidizing sputtering gas flow ratio at the time of film formation. When the content of oxygen atoms in the target is constant, the smaller the oxidizing sputtering gas flow ratio becomes, the smaller the oxygen content in the film becomes.

(IN A CASE WHERE THE TARGET IS METAL OXIDE)

At the time of forming the precursor layer for the seed layer 11 a, for example, in a case where the target is made of a metal oxide (M:$TiO_{2-\delta 1}$, $0 \leqq \delta 1 \leqq 1.5$), the sputtering gas to be used may be one having even a small amount of oxidizing gas incorporated to an inert gas. The oxidizing sputtering gas flow ratio is preferably at least 0.1 vol%, more preferably at least 0.25 vol%. The upper limit of the oxidizing sputtering gas flow ratio is 100 vol%.

The oxidizing sputtering gas flow ratio at the time of forming the precursor layer for the interlayer 11 b is preferably less than 0.1 vol%, more preferably less than 0.05 vol%. It may be 0 (zero) vol% i.e. no oxidizing sputtering gas may be incorporated to the inert gas as sputtering gas. Further, in addition to the oxidizing sputtering gas, hydrogen ($H_2$) gas may further be incorporated. In such a case, the flow ratio of hydrogen gas to 100 parts by volume of the total flow rate of the sputtering gas is preferably at least 0.01 part by volume and at most 50 parts by volume. If the flow ratio of hydrogen gas is smaller than the above range, the effect for adding hydrogen gas tends to be inadequate, and if it exceeds the above range, metal titanium is likely to be formed by excessive reduction.

The oxidizing sputtering gas flow ratio at the time of forming the precursor layer for the main layer 11, is the same as for the interlayer 11 b including the preferred embodiment.

The sputtering gas at the time of forming the precursor layer for the protective layer 12 is the same as for the interlayer 11 b including a preferred embodiment in order to accomplish the low resistance.

The composition and gas flow ratio of the sputtering gas at the time of forming each layer, are determined by selecting the best conditions within the above ranges, taking into consideration the nature of the target, etc.

(IN A CASE WHERE TARGET IS METAL)

The oxidizing sputtering gas flow ratio at the time of forming the precursor layer for the seed layer 11 a, is preferably at least 7.5 vol%, more preferably at least 10 vol%. It may be 100 vol%.

The oxidizing sputtering gas flow ratio at the time of forming the precursor layer for the interlayer 11 b, is preferably within a range of from 3 vol% to 7.5 vol%, more preferably from 5 vol% to 7 vol%. If the oxidizing sputtering gas flow ratio is smaller than the above range, metal titanium is likely to be formed due to oxidation deficiency.

The concentration of the oxidizing sputtering gas in the atmospheric gas at the time of forming the precursor for the interlayer 11 b is preferably lower than the concentration of the oxidizing sputtering gas in the atmospheric gas at the time of forming the precursor for the seed layer 11 a, since it is thereby possible to form a layer having high transparency and high electric conductivity. Further, in such a case, the types of the respective oxidizing gases should preferably be the same.

The oxidizing sputtering gas flow ratio at the time of forming the precursor layer for the main layer 11, is the same as for the interlayer 11 b including the preferred embodiment.

The oxidizing sputtering gas flow ratio at the time of forming the precursor layer for the protective layer 12 is preferably at least 5 vol%, more preferably at least 7.5 vol%, in order to accomplish the low resistance. The upper limit of the oxidizing sputtering gas flow ratio is 100 vol%. The composition and the gas flow ratio of the sputtering gas at the time of forming each layer are determined by selecting the best conditions within the above ranges taking into consideration the nature of the target, etc.

(B) CONTENT OF OXYGEN ATOMS IN TARGET

Further, in the sputtering method, as a method for controlling the oxygen content in the film, (B) a method of controlling the content of oxygen atoms in the target to be used for the film formation, may be employed.

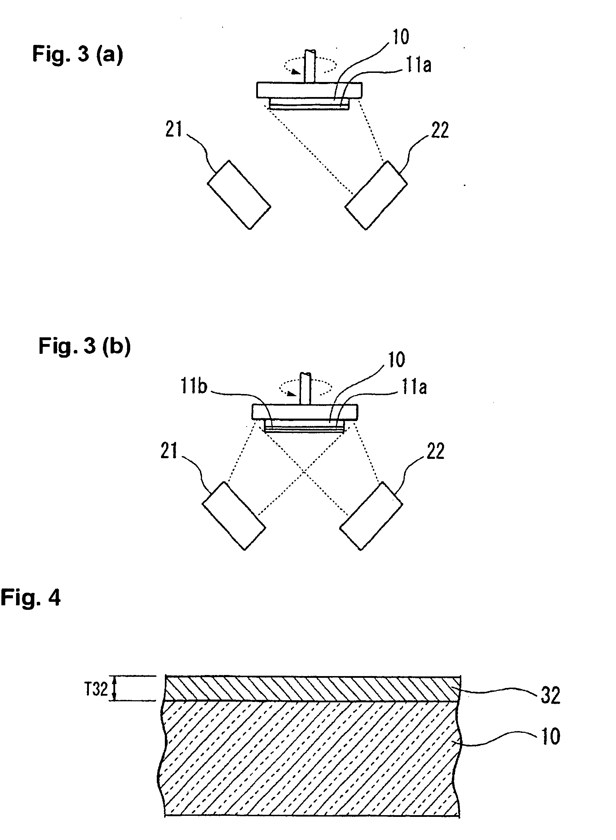

With respect to the content of oxygen atoms in the target, for example, as shown in Fig. 3, by using a metal target 21 and a metal oxide target 22 are used at the same time for film formation, the content of oxygen atoms in the target to be used for the film formation can be made smaller than a case where only the metal oxide target is used for the film formation.

Specifically, both the metal target 21 and the metal oxide target 22 are preliminarily set in the vacuum chamber on the side opposing to the substrate 10. And, a voltage is applied to the metal target 21 and/or the metal oxide target 22 to carry out film forming on the substrate 10, while rotating the substrate 10. The dopant contents in the metal target 21 and the metal oxide target 22 are preferably the same.

In this method, in a case where the concentration of the oxidizing sputtering gas in the atmospheric gas is constant, and the sizes of the metal target 21 and the metal oxide target 22 are the same, the larger the ratio of "input power to the metal target/input power to the metal oxide target" becomes, the smaller the oxygen content in the film becomes.

The content of oxygen atoms in the target to be used at the time of forming the precursor layer for the interlayer 11 b is preferably lower than the content of oxygen atoms in the target to be used at the time of forming the precursor layer for the seed layer 11 a, since it is thereby possible to form a layer having high transparency and high electric conductivity. Further, in such a case, the dopant contents in the respective targets are preferably the same.

For example, in a case where the oxidizing sputtering gas flow ratio is made constant within a range of at most 0.1 vol% at the time of forming the precursor layer for the seed layer 11 a and the time of forming the precursor layer for the interlayer 11 b, by using a metal oxide target 22 made of a metal oxide ($M:TiO_{2-\delta 2}$: $0 \leqq \delta 2 \leqq 1.5$) and a metal target 21 made of an alloy of M and Ti, when the precursor layer for the seed layer 11 a is formed, it is preferred that, as shown in Fig. 3(a), a voltage is applied only on the metal oxide target 22, and the voltage applied to the metal target 21 is 0.

Then, when the precursor layer for the interlayer 11 b is formed, as shown in Fig. 3(b), a voltage is applied to both the metal target 21 and the metal oxide target 22. For example, in a case where the discharge manner of the metal oxide target is RF discharge (high frequency discharge), the discharge manner of the metal target is DC discharge, and the areas of the targets are the same, to satisfy the above conditions (1) and/or (2), the ratio of the electric power (unit: W) applied to the metal target is preferably from 5 to 40% based on the electric power (unit: W) applied to the metal oxide target being 100%.

[PLD METHOD]

Each precursor layer may be formed by a PLD method.

In the PLD method, for example, a substrate and a target are disposed to face each other in a chamber which can maintain an appropriate depressurized state, oxygen gas is injected into the chamber and at the same time, the oxygen partial pressure in the chamber is maintained at a predetermined level, and the substrate temperature is set at a predetermined temperature, and while the substrate and the target are rotated, the target is intermittently irradiated with a pulsed laser light to rapidly increase the temperature of the surface of the target to produce abrasion plasma. Ti atoms, O atoms and M (dopant) atoms contained in the abrasion plasma gradually change their state as they repeatedly collide and react with oxygen gas in the chamber and move to the substrate, and particles containing Ti atoms, M atoms and O atoms reached the substrate are, as they are, dispersed on the surface of the substrate to form a thin film. Thus, the film is formed on the substrate.

As the pulsed laser light, for example, KrF excimer laser light having a pulse frequency of from 1 to 10 Hz, a laser fluence (laser power) of from 1 to 2 J/cm$^2$ and a wavelength of 248 nm may be used. The pressure in the exhaust side of the chamber is preferably always maintained to be 10$^{-3}$ Torr (1.33$\times$10$^{-1}$ Pa) or lower.

As the target, for example, a metal oxide target is used. The metal oxide target is the same as used in the sputtering method. The content of the dopant in the target is substantially equal to the content of the dopant in the film formed by using such a target.

[SUBSTRATE TEMPERATURE]

The substrate temperature at the time of forming each precursor layer is the same as in the sputtering method.

Further, in the PLD method, the temperature range which the substrate temperature can take at the time of film formation without heating the substrate, i.e. the range of "room temperature" for the substrate temperature during the film formation is at a level of from 25 to 100°C.

The above-mentioned respective conditions (X1), (X2), (Y1) and (Y2) in the case of forming the precursor layer by the PLD method, are the same as in the sputtering method. The single layer annealing test is also the same except that the film forming method is different.

[(C) OXYGEN PARTIAL PRESSURE]

In the case of the PLD method, as a method for controlling the oxygen content in the film, (C) a method of controlling the oxygen partial pressure at the time of film formation, is preferred.

In a case where the content of oxygen atoms in the target is constant, the lower the oxygen partial pressure at the time of film formation, the lower the oxygen content in the film.

For example, in a case where the target is made of a metal oxide (M:TiO$_{2-\delta3}$: $0 \leqq \delta3 \leqq 1.5$), the oxygen partial pressure at the time of forming the precursor layer for the seed layer 11 a is preferably at least 5$\times$10$^{-1}$ Pa, more preferably at least 1$\times$10$^0$ Pa. Further, the upper limit value of the oxygen partial pressure is preferably 1$\times$10$^5$ Pa from the viewpoint of the productivity.

On the other hand, the oxygen partial pressure at the time of forming the precursor layer for the interlayer 11b is preferably less than 5$\times$10$^{-1}$ Pa, more preferably at most 3$\times$10$^{-1}$ Pa. Further, the lower limit value of such an oxygen partial pressure is preferably 1$\times$10$^{-8}$ Pa with a view to securing the transparency.

The oxygen partial pressure at the time of forming the precursor layer for the main layer 11 is the same as for the seed layer including the preferred embodiment.

The oxygen partial pressure at the time of forming the precursor layer for the protective layer 12 is preferably at least 10$^{-3}$ Pa, more preferably at least 10$^{-2}$ Pa, in order to accomplish the low resistance.

[ATMOSPHERIC ANNEALING STEP]

In the present invention, annealing means an operation to raise the temperature to a predetermined temperature (annealing temperature) by heating and then lower the temperature. In a case where at least two precursor layers are formed on the substrate 10 as in this embodiment, the substrate temperature may be applied as the annealing temperature. The heat-treating temperature in the atmospheric annealing step is at least the highest temperature among the respective crystallization temperatures of the plurality of precursor layers formed on the substrate 10 and lower than the electric conductivity-deteriorating temperature of the precursor layer (second precursor layer) for the protective layer 12.

[DEFINITION OF CRYSTALLIZATION TEMPERATURE]

In the present invention, the crystallization temperature of a precursor layer is a value obtained by the following method.

That is, a precursor layer is formed on a substrate as a single layer, heated in vacuum until the substrate temperature rises from room temperature to 600°C over a period of 200 minutes, then the temperature is maintained for one hour and then immediately cooled to room temperature over a period of 200 minutes, whereby the relation between the substrate temperature and the specific resistance is examined. From the result, the temperature T'(°C) at which the specific resistance value decreases most during the heating is obtained, and the temperature lower by 30°C than the T' (T'-30) is defined to be the crystallization temperature Tcr (°C). The temperature at which the specific resistance value decreases most during the heating, is obtained from the relation between the first derivation value of the specific resistance and the substrate temperature.

Here, the crystallization temperature in the present invention is not a temperature at which the amorphous becomes complete polycrystals during the process wherein the amorphous changes to polycrystals by heating, but means a temperature at which low resistance is obtainable even if polycrystals and amorphous are present as mixed. Therefore, a value lower by 30°C than the temperature T' at which the specific resistance value decreases most during the heating, is taken as the crystallization temperature Tcr.

[DEFINITION OF ELECTRIC CONDUCTIVITY-DETERIORATING TEMPERATURE]

In the present invention, the electric conductivity-deteriorating temperature of the precursor layer for the protective layer 12 is a value obtained by the following method.

That is, a precursor layer for a protective layer 12 is formed on a substrate in a single layer and annealed under such conditions that it is heated from room temperature to 600°C over a period of 6 minutes in a hydrogen atmosphere under 1 atm, then maintained at 600°C for one hour and then immediately cooled to room temperature over a period of 30 minutes, to obtain a poly-crystallized layer, which is used as a sample film.

The sample film thus obtained is subjected to a heating test by a method wherein it is heated from room temperature to 600°C over a period of 200 minutes in the atmosphere and then immediately left to cool, whereby the relation between the substrate temperature and the specific resistance is examined. A temperature at which the specific resistance value increases most during the heating, i.e. a temperature at a point where the first deviation graph bends (the inclination changes most) is defined to be the electric conductivity-deteriorating temperature Td (°C).

Here, the electric conductivity-deteriorating temperature of the precursor layer in this invention is the electric conductivity-deteriorating temperature of the sample film poly-crystallized by annealing the precursor layer. Therefore, such an electric conductivity-deteriorating temperature is substantially the electric conductivity-deteriorating temperature of the protective layer 12 after annealing.

The atmospheric annealing temperature is within such a range that it is at least the highest crystallization temperature thus obtained and lower than the electric conductivity-deteriorating temperature of the precursor layer for the protective layer 12. For example, it is preferably from about 300 to 400°C.

The time for maintaining the temperature at the predetermined annealing temperature (annealing time) is not particularly limited and may suitably be set so that the desired properties can be obtained after the annealing. If the annealing temperature is low, a long annealing time tends to be required. The annealing time is preferably, for example, within a range of from 1 to 120 minutes, more preferably from 1 to 60 minutes, although it may depends also on the conditions other than the annealing temperature.

In the atmospheric annealing step, each precursor layer is heated at a temperature higher than its crystallization temperature and thus polycrystallized to form an electric conductor layer.

Further, as the outermost layer, the precursor layer for the protective layer 12 is provided, and heating is carried out at a temperature lower than the electric conductivity-deteriorating temperature of the precursor layer for the protective layer 12, whereby even if the annealing is carried out in the atmosphere, the electric conductivity of the protective layer 12 will not be deteriorated. In the protective layer 12, the dopant concentration is within a specific low range, whereby oxygen atoms are scarcely taken into the film during the heating, which is considered to be contributing to the high heat resistance of the protective layer 12.

And, such a precursor layer for the protective layer 12 is provided as the outermost layer, the precursor layers for the main layer 11, or the seed layer 11 a and the interlayer 11 b present between the protective layer 12 and the substrate 10, are heated in a state free from contact with oxygen even though the annealing is carried out in the atmosphere. Accordingly, even if the atmospheric annealing temperature is higher than the electric conductivity-deteriorating temperatures of these layers in the atmosphere, oxygen is scarcely taken into these layers, whereby deterioration of the electric conductivity is prevented. That is, the heat resistance is improved.

By the process of the present invention, it becomes possible to form an electric conductor by the atmospheric annealing by forming a precursor layer for the protective layer 12 as a precursor layer constituting the outermost layer. The atmospheric annealing is advantageous from the viewpoint of the installation and the required time, as compared with annealing in a reducing atmosphere.

Further, the electric conductor thereby obtainable has good transparency, and the electric conductivity will not be impaired even if heated in the atmosphere so long as the heating temperature is lower than the electric conductivity-deteriorating temperature of the protective layer 12. Therefore, it can be used as a transparent conductor film having good heat resistance.

<SECOND PRODUCTION PROCESS>

The electric conductor of the present invention can be produced also by a process wherein after forming the respective precursor layers in the same manner as in the first production process, annealing is carried out by heating in a reducing atmosphere (reduction annealing step) instead of the atmospheric annealing step.

In the present invention, the reducing atmosphere means that the partial pressure of oxidizing gas in the annealing atmosphere is at most $0.2 \times 10^5$ Pa. Such oxidizing gas means a gas capable of giving oxygen to the precursor layer in the annealing step, and specific examples include $O_2$, $O_3$, $NO$, $NO_2$, $H_2O$, etc. In a case where two or more oxidizing gases are contained in the atmosphere, the sum of their partial pressures may be within the above range. The partial pressure of oxidizing gas in the reducing atmosphere is preferably at most $1 \times 10^4$ Pa, more preferably at most 10 Pa, most preferably at a level of $1 \times 10^{-8}$ Pa. As the value of the partial pressure of oxidizing gas is small, it becomes possible to obtain an electric conductor having a lower resistance.

Further, in order to further reduce the resistance, it is preferred to let $H_2$ and/or CO be present in the reducing atmosphere, and it is more preferred to let $H_2$ in a plasma state be present. Accordingly, it is preferred to bring the annealing atmosphere to be in a vacuumed state once, then introduce hydrogen ($H_2$) and carry out the annealing.

Otherwise, it is preferred to make the reducing atmosphere for annealing to be in a vacuumed state.

In this specification, the atmospheric pressure in a vacuumed state is within a range of from $10^3$ to $10^{-8}$ Pa, preferably within a range of $10^0$ to $10^{-8}$ Pa, more preferably within a range of from $10^2$ to $10^{-8}$ Pa.

The heat-treating temperature in the reduction annealing is the same as in the first production process in that it is at least the highest temperature among the respective crystallization temperatures of the plurality of precursor layers formed on the substrate 10.

On the other hand, in the reduction annealing, the heat-treatment is carried out in a state where oxygen is scarcely taken into the film as compared with the atmospheric annealing, whereby deterioration of the electric conductivity is less likely to take place even when the heating temperature is high. That is, the electric conductivity-deteriorating temperature is high, and accordingly, the upper limit of the annealing temperature is higher in the reduction annealing than in the atmospheric annealing.

The upper limit of the annealing temperature in the reduction annealing is a temperature at which an anatase crystal structure will break in the annealing step, and for example, it is preferably at most 900°C. From the viewpoint of the heat resistance of the substrate 10, the energy reduction, shortening of the temperature raising time, etc., the annealing temperature is preferably as low as possible. A more preferred range of the annealing temperature in the reduction annealing is from 200 to 650°C, more preferably from 300 to 600°C.

The time for maintaining the temperature at the predetermined annealing temperature (annealing time) is not particularly limited and may suitably be set so that the desired properties can be obtained after the annealing. If the annealing temperature is low, a long annealing time tends to be required. The annealing time is, for example, preferably within a range of from 1 to 120 minutes, more preferably from 1 to 60 minutes, although it depends also on the conditions other than the annealing temperature.

<PROCESS OF THE PRESENT INVENTION>

The process of the present invention is suitable also for forming an electric conductor layer 32 having high heat resistance directly on the substrate 10, as shown in Fig. 4.

That is, the electric conductor having the electric conductor layer 32 formed on the substrate 10 is obtainable by forming on the substrate 10 a precursor layer made of titanium oxide doped with at least one dopant selected from the group consisting of Nb, Ta, Mo, As, Sb, W, N, F, S, Se, Te, Cr, Ni, Tc, Re, P and Bi, wherein the percentage of the number of dopant atoms based on the total number of titanium and dopant atoms is from 0.01 to 4 atomic% (precursor layer-forming step), and heat-treating the precursor layer in the atmosphere in a temperature range of at least the crystallization temperature and lower than the electric conductivity-deteriorating temperature of the precursor layer (atmospheric annealing step).

The substrate 10 is the same as in the above-described first embodiment of the electric conductor. Preferred types of the dopant are also the same as in the above-described first embodiment of the electric conductor.

The content of the dopant in the electric conductor layer 32 is at least 0.01 atomic% and at most 4 atomic%. When it is at least 0.01 atomic%, electric conductivity can be obtained, and when it is at most 4 atomic%, good heat resistance can be obtained. A more preferred range is from 0.2 to 4 atomic%, and from 0.5 to 3 atomic% is further preferred.

The thickness T32 of the electric conductor layer 32 is preferably at least 3 nm. If the thickness is thinner than 3 nm, the time wherein the heat resistance can be maintained, tends to be short. It is preferably at least 10 nm. The upper limit is not particularly limited, but if it is too thick, the transparency deteriorates, and the time required for the production tends to be long. It is preferably at most 100 nm, more preferably at most 30 nm.

Specifically, firstly, a precursor layer for the electric conductor layer 32 is formed on the substrate 10. The precursor layer is an amorphous layer. The precursor layer can be formed by optionally using a known film forming method in the same manner as in the first embodiment of the electric conductor.

Especially, the PLD method is preferred, since a good film state can easily be obtained, and the sputtering method is preferred since the film can be easily formed irrespective of the crystallinity of the substrate.

In a case where the precursor layer for the electric conductor layer 32 is to be formed by the PLD method, the target is the same as in the above-mentioned first production process. The precursor layer is an amorphous layer, and accordingly, the substrate temperature is preferably at most room temperature. The oxygen partial pressure during the film formation is preferably at least $10^{-3}$ Pa, more preferably at least $10^{-2}$ Pa, in order to accomplish low resistance.

The test can be carried out in the same manner as the film formation of the precursor layer for the protective layer 12 in the above-described first production process.

In a case where the precursor layer for the electric conductor layer 32 is formed by the sputtering method, the target is the same as in the above first production process. The substrate temperature is preferably at most room temperature. The sputtering pressure is preferably from about 0.1 to 10 Pa.

The inert gas is the same as in the first production process. The ratio of $O_2$/(inert gas+$O_2$) in the sputtering gas (by volume) is preferably from about 0 to 1 vol%.

The rest may be carried out in the same manner as in the film formation of the precursor layer for the protective layer 12 in the above-described first production process.

The precursor layer thus formed is subjected to atmospheric annealing. The annealing temperature is within a temperature range of at least the crystallization temperature and lower than the electric conductivity-deteriorating temperature of the precursor layer.

The rest can be carried out in the same manner as in the atmospheric annealing step in the first production process.

Thus, an electric conductor having an electric conductor layer 32 with high heat resistance formed on the substrate 10, is obtainable. Such an electric conductor also has a good transparency and can be used as a transparent electric conductor film having good heat resistance with a high electric conductivity-deteriorating temperature.

<APPLICATIONS>

The electric conductor of the present invention has a wide application range, and for example, it is useful for transparent electrodes for e.g. flat panel displays, solar cells, touch panels, etc.

EXAMPLES

Now, the present invention will be described in further detail with reference to Examples, but it should be understood that the present invention is by no means restricted to these Examples.

EXAMPLE 1: MEASUREMENT OF CRYSTALLIZATION TEMPERATURE

Using a PLD apparatus, an amorphous layer (precursor layer) was formed on a substrate under the following conditions.

Substrate: a glass substrate having a thickness of 0.5 mm made of non-alkali glass (model name: AN100, manufactured by Asahi Glass Company, Limited)
Film-forming method: PLD method
Oxygen partial pressure during film formation: $1.33 \times 10^{-1}$ Pa ($1 \times 10^{-3}$ Torr)
Target: $TiO_2$ sintered body
Substrate temperature: room temperature (no heating of the substrate)

The obtained amorphous layer had a thickness of 130 nm and a Nb content of 0 atomic%. This amorphous layer was heated from room temperature to 600°C over a period of 200 minutes in vacuum, then maintained for one hour and then cooled to room temperature over a period of 200 minutes, whereby the relation between the substrate temperature and the specific resistance was examined.

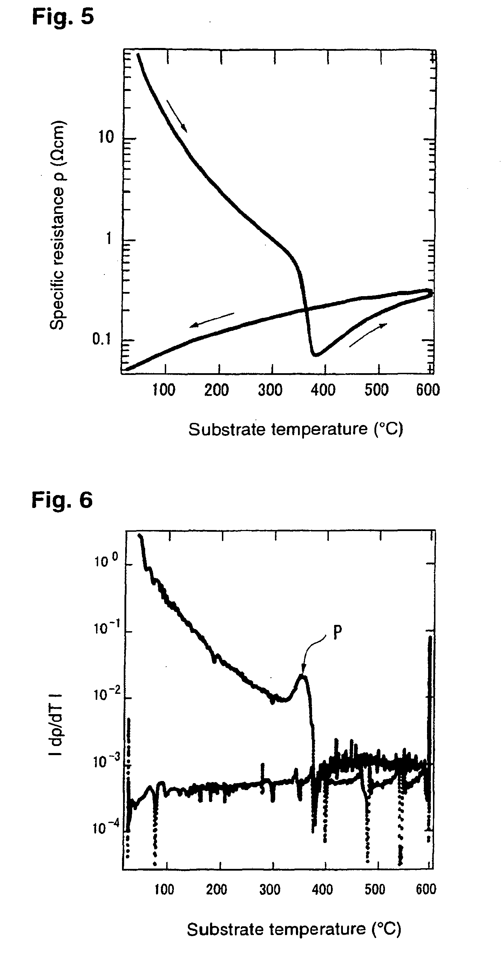

The results are shown in Fig. 5.

In Fig. 5, the ordinate axis represents the specific resistance ρ (unit: Ωcm), and the abscissa axis represents the substrate temperature T (unit: °C).

Fig. 6 is one illustrating the relation between the absolute value of the first derivation (dρ/dT) of the specific resistance ρ shown by the ordinate axis in Fig. 5 and the substrate temperature T.

When, in Fig. 5, the temperature at which the specific resistance value decreases most during the heating, i.e. the temperature at which the peak P of the first derivation value is obtainable in Fig. 6, is represented by T'(°C), T'-30 (°C) is the crystallization temperature Tcr (°C).

EXAMPLE 2: RELATION BETWEEN CRYSTALLIZATION TEMPERATURE AND AMOUNT OF DOPANT

Amorphous layers having a Nb content of from 0 to 15 atomic% were formed in the same manner as in the above Example 1 except that the target composition was changed among the production conditions for the amorphous layer, and in the same manner, the crystallization temperature Tcr was measured. As the target, a $TiO_2$ sintered body made of Nb:$TiO_{2-\delta}$(Nb/(Ti+Nb)=0, 1, 3, 4, 6, 10 or 15 atomic%) was used.

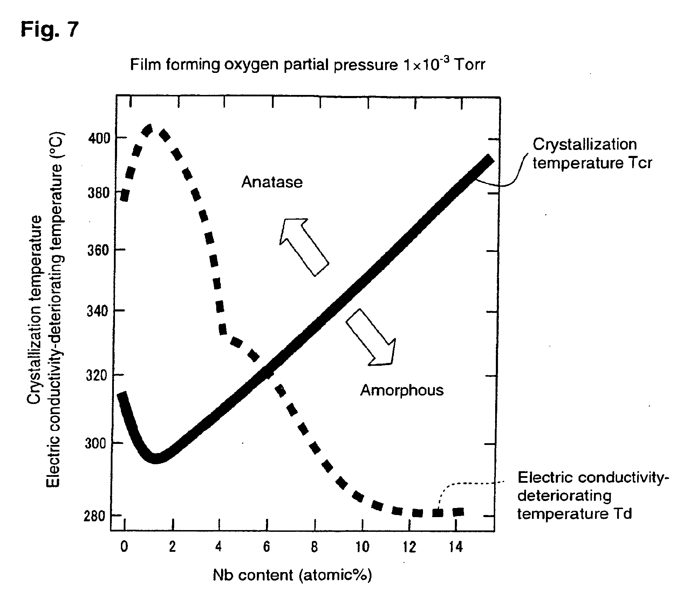

The relation between the Nb content (atomic%) and the crystallization temperature Tcr (°C) is shown by a solid line in Fig. 7.

EXAMPLE 3: MEASUREMENT OF ELECTRIC CONDUCTIVITY-DETERIORATING TEMPERATURE AND THE RELATION WITH THE AMOUNT OF DOPANT

Amorphous layers having a Nb content of from 0 to 15 atomic% were formed in the same manner as in the above Example 1 except that the target composition was changed among the production conditions for the amorphous layer. As the target, a $TiO_2$ sintered body made of Nb:$TiO_{2-\delta}$(Nb/(Ti+Nb)=0, 1, 3, 4, 6, 10 or 15 atomic%) was used.

Then, one subjected to annealing under such conditions that it was heated from room temperature to 600°C over a period of 6 minutes in a hydrogen atmosphere under 1 atm, then maintained for one hour and then cooled to room temperature over a period of 15 minutes, was used as a sample film.

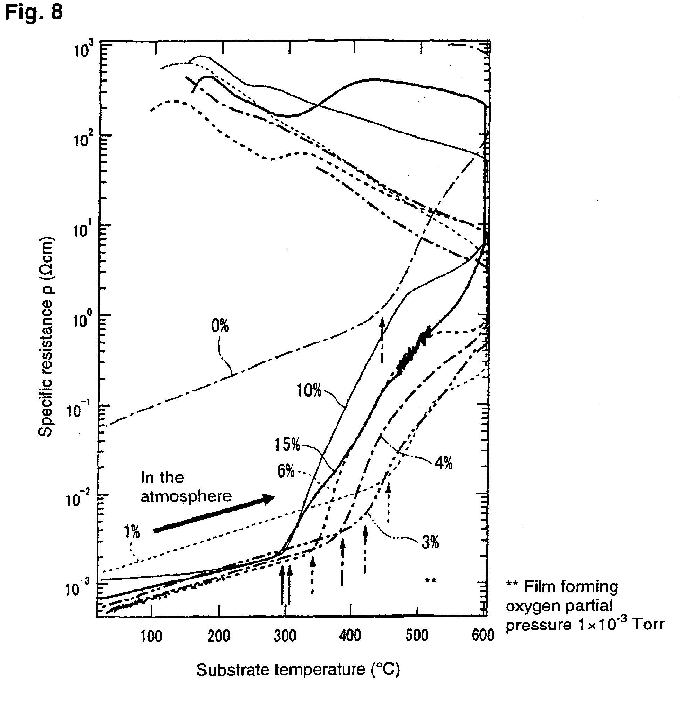

The sample film thus obtained was subjected to a heating test by a method wherein it was heated from room temperature to 600°C over a period of 200 minutes in the atmosphere, then maintained for one hour and then left to cool. At that time, the relation between the substrate temperature and the specific resistance was examined. The results are shown in Fig. 8.

In Fig. 8, the ordinate axis represents the specific resistance p (unit: $\Omega$cm), and the abscissa axis represents the substrate temperature T (unit: °C).

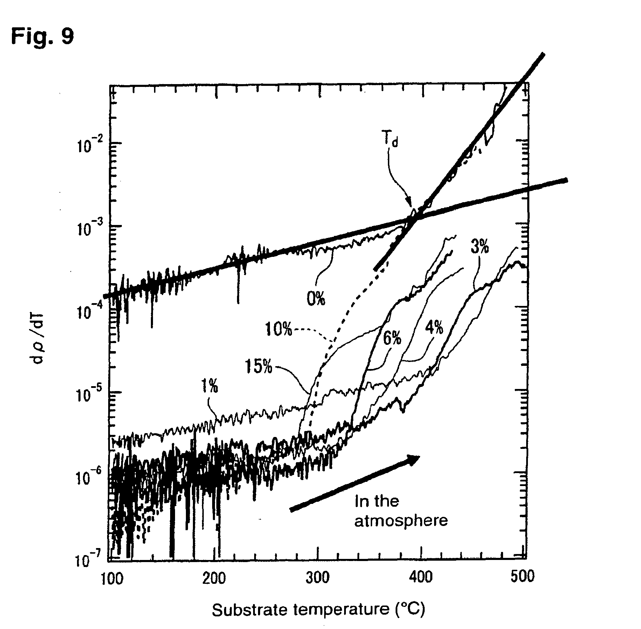

Fig. 9 is a graph showing the relation between the first derivation (dp/dT) of the specific resistance p during the temperature rise shown by the ordinate axis in Fig. 8, and the substrate temperature T.

In Fig. 8, a temperature at which the specific resistance value increases most during the heating (shown by an arrow in the Fig), i.e. a temperature at a point where in Fig. 9, the first derivation graph bends (the inclination changes most), is the electric conductivity-deteriorating temperature Td (°C).

The relation between the Nb content (atomic%) and the electric conductivity-deteriorating temperature Td (°C) is shown by a dotted line in Fig. 7.

In Fig. 8, the specific resistance of the sample film at the time of initiation of the heating test is low in each case except for the one having a Nb content of 0%, and thus it is evident that by annealing, the sample film was poly-crystallized to lower the resistance.

It is considered that the sample film having a Nb content of 0% was polycrystallized, but it contained no Nb, whereby the specific resistance was not sufficiently lowered.

And from the result in Fig. 8, it is evident that when the sample film having the resistance reduced by annealing is further heated in the atmosphere, the specific resistance sharply increases in the vicinity of from 300 to 400°C, whereby the electric conductivity will deteriorate. And as shown in Fig. 7, the temperature at which the electric conductivity deteriorates (electric conductivity-deteriorating temperature Td) depends on the Nb content.

In Fig. 7, within a range of the Nb content being from 0.01 to 4 atomic%, the electric conductivity-deteriorating temperature Td is sufficiently higher than the crystallization temperature Tcr. Accordingly, for example, when an amorphous layer having a Nb content of 1 atomic% is heated in the atmosphere, if the substrate temperature becomes at least 290°C as the crystallization temperature Tcr, the amorphous layer is poly-crystallized whereby the resistance will be low. And, when the substrate temperature reaches 400°C as the electric conductivity-deteriorating temperature Td, the electric conductivity deteriorates, and the specific resistance sharply increases. Accordingly, it is evident that when an amorphous layer having a Nb content of 1 atomic% is heated within a range where the substrate temperature is at least 290°C and lower than 400°C in the atmosphere, a polycrystal film having a low resistance can be obtained.

EXAMPLE 4: RELATION BETWEEN ELECTRIC CONDUCTIVITY-DETERIORATING TEMPERATURE AND THE AMOUNT OF DOPANT

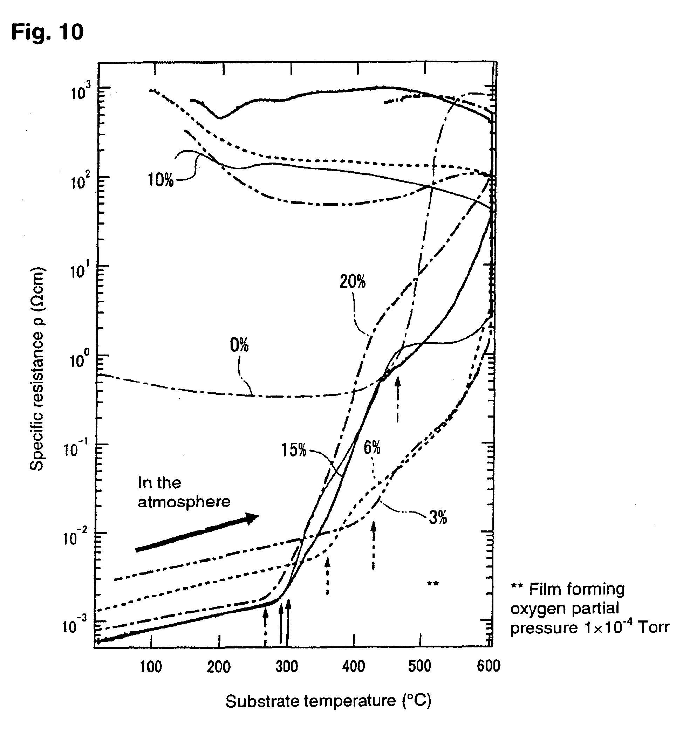

A sample film was formed in the same manner as in Example 3 except that the oxygen partial pressure at the time of forming an amorphous layer was changed to $1.33 \times 10^2$ Pa ($1 \times 10^4$ Torr), and with respect to such a sample film, a heating test was carried out, whereby the relation between the substrate temperature and the specific resistance was examined. The results are shown in Fig. 10. Here, the target composition was Nb:TiO$_{2-\delta}$ (Nb/(Ti+Nb)=0, 3, 6, 10, 15 or 20 atomic%).

Figs. 10 and 8 show the same tendency with respect to the electric conductivity-deteriorating temperature, and it is evident that the oxygen partial pressure at the time of forming the amorphous layer is not substantially influential over the electric conductivity-deteriorating temperature.

EXAMPLE 5: INFLUENCE OF OXYGEN PARTIAL PRESSURE DURING FILM FORMATION

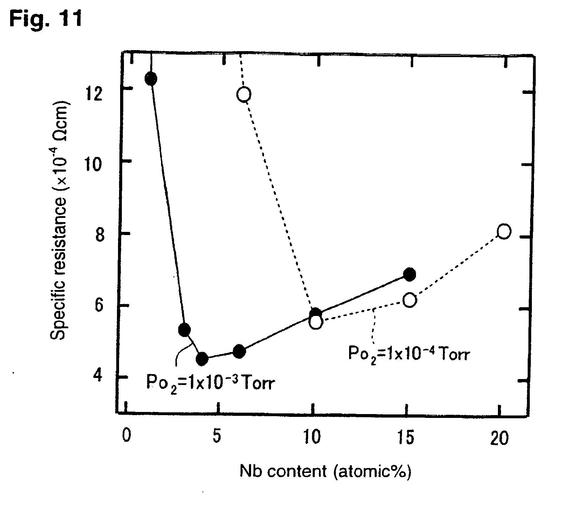

Fig. 11 is a graph wherein the specific resistance of sample films at the initiation of the heating tests in Examples 3 and 4 (Figs. 8 and 10) i.e. the films having the resistance reduced by annealing, is represented by the coordinate axis, and the Nb content is represented by the abscissa axis. The solid line represents a case where the oxygen partial pressure during the film formation of the amorphous layer was $1.33 \times 10^{-1}$ Pa ($\times 10^{-3}$ Torr), and the dotted line represents a case where it was $1.33 \times 10^2$ Pa ($1 \times 10^{-4}$ Torr). From the results in this Fig, it is evident that the oxygen partial pressure during the film formation of the amorphous layer is influential over the specific resistance of the film after annealing, and within a range where the Nb content is lower than 10 atomic%, a lower specific resistance can be obtained under $1 \times 10^{-3}$ Torr.

Further, it is evident that especially in the case of forming an amorphous layer (precursor layer) having a Nb content of 4 atomic%, when the oxygen partial pressure is adjusted to $1 \times 10^{-3}$ Torr, a lower specific resistance can be obtained, and it is possible to accomplish a specific resistance at a level of $4 \times 10^{-4}$ $\Omega$cm.

EXAMPLE 6: LIGHT ABSORPTION PROPERTY

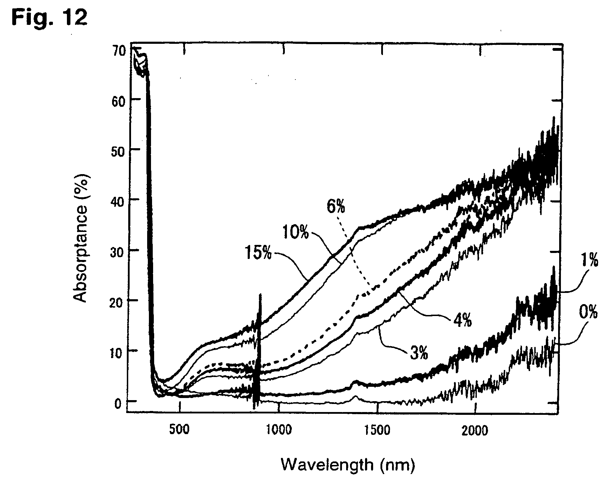

Fig. 12 is one showing the results of measuring the light absorption property with respect to the sample film at the initiation of the heating test in Example 3 (Fig. 8) i.e. the film having the resistance reduced by annealing. In Fig. 12, the abscissa axis represents the wavelength (nm), and the ordinate axis represents the absorptance (%).

From the results in this Fig., it is evident that one having a lower Nb content has a lower light absorptance and a higher transparency.

From Figs. 11 and 12, it is evident that when an amorphous layer having a Nb content within a range of from 0.01 to 4 atomic% is made to have the resistance lowered by annealing, it is possible to obtain a transparent electric conductor film which has a low specific resistance and is excellent also in the transparency. Further, as shown by the dotted line in Fig. 7, when the Nb content is within this range, the electric conductivity-deteriorating temperature Td is high when heated in the atmosphere, and the electric conductivity of the film will not deteriorate unless the substrate temperature reaches the electric conductivity-deteriorating temperature Td (e.g. from 330 to 400°C). That is, a transparent electric conductor film obtained by annealing an amorphous layer having a Nb content within a range of from 0.01 to 4 atomic%, shows good heat resistance in the atmosphere.

WORKING EXAMPLE 1

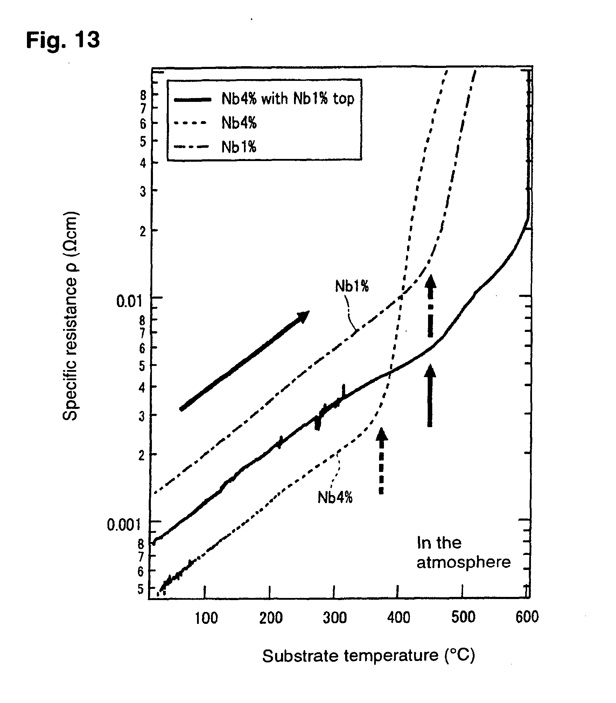

An electric conductor having a structure shown in Fig. 1 was prepared.
In the same manner as in Example 3, an amorphous layer having a Nb content of 4 atomic% (thickness: 100 nm,) was formed as a precursor layer for the main layer 11 on a substrate, and then, by changing the target, an amorphous layer having a Nb content of 1 atomic% (thickness: 30 nm) was formed as a precursor layer for the protective layer 12 thereon. The oxygen partial pressure during the film formation was $1.33 \times 10^{-1}$ Pa ($1 \times 10^{-3}$ Torr) in each case.
The laminate thus obtained was subjected to annealing under such conditions that it was heated from room temperature to 600°C over a period of 6 minutes in vacuum, then maintained for one hour and then cooled to room temperature over a period of 15 minutes, to obtain a sample film (laminate).
The obtained sample film (laminate) was subjected to a heating test in the atmosphere in the same manner as in Example 3, whereby the relation between the substrate temperature and the specific resistance was examined. The results are shown by a solid line in Fig. 13. In this Fig., the results with a Nb content of 4 atomic% and 1 atomic% in Fig. 8 are shown by a dotted line.
It is evident that as compared with a sample film composed of a single layer having a Nb content of 4 atomic%, the sample film (laminate) in this Example has the heat resistance improved by laminating, as the outermost layer, a layer having a Nb content of 1 atomic% and having a high electric conductivity-deteriorating temperature Td.

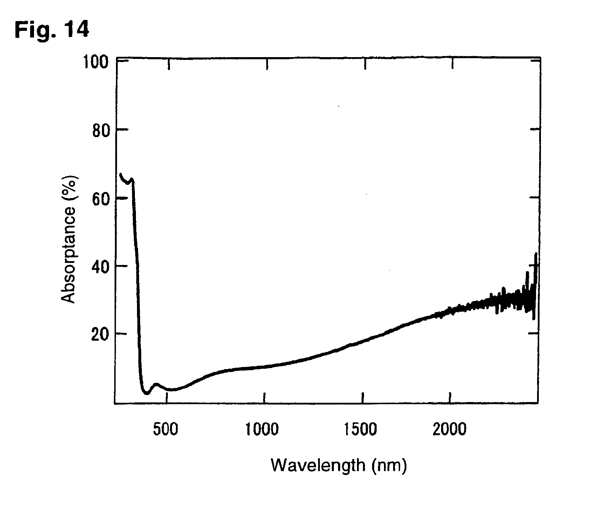

Fig. 14 is one showing the results of measuring the light absorption property with respect to the sample film (laminate) in this Example. It is evident that even when compared with the results with a Nb content of 4 atomic% as shown in Fig. 12, the light absorptance is not inferior, and the transparency is not impaired by laminating the layer having a Nb content of 1 atomic%.

WORKING EXAMPLE 2

An electric conductor having a structure shown in Fig. 2 was prepared.
In the same manner as in Example 3, an amorphous layer having a Nb content of 1 atomic% (thickness: 25 nm,) was formed as a precursor layer for the seed layer 11 a on a substrate, and then, by changing the target, an amorphous layer having a Nb content of 4 atomic% (thickness: 120 nm) was formed as a precursor layer for an interlayer 11 b thereon, and by further changing the target, an amorphous layer having a Nb content of 1 atomic% (thickness: 25 nm) was formed as a precursor layer for the protective layer 12 thereon. The oxygen partial pressure during the film formation was $2.66 \times 10^{-1}$ Pa ($2 \times 10^{-3}$ Torr) for the seed layer, $1.33 \times 10^{-1}$ Pa ($1 \times 10^{-4}$ Torr) for the interlayer, and $1.33 \times 10^{-1}$ Pa ($1 \times 10^{-3}$ Torr) for the protective layer.
The laminate thus obtained was subjected to annealing in the atmosphere under such conditions that it was heated from room temperature to 350°C over a period of 3 minutes in the atmosphere, then maintained at 350°C for 60 minutes and then cooled to room temperature over a period of 15 minutes, to obtain a sample film (laminate).

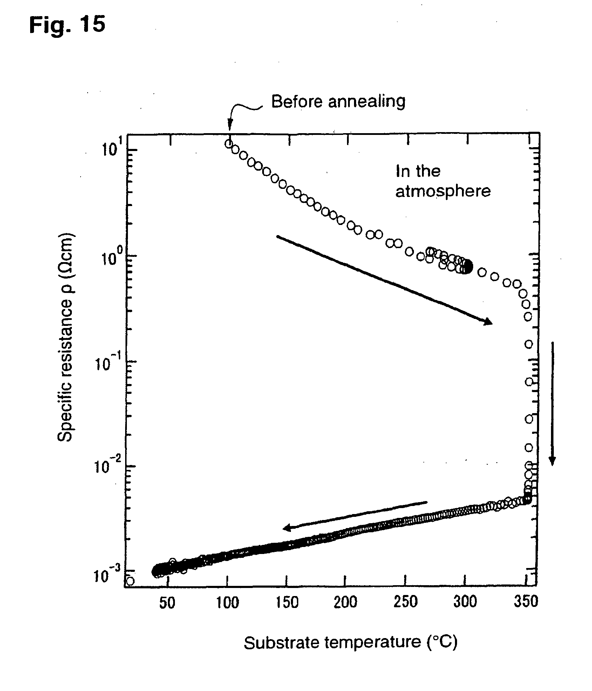

Fig. 15 is one showing the relation between the substrate temperature and the specific resistance of the sample film in the annealing step. After the annealing, an electric conductor film having a specific resistance=$8.51 \times 10^{-4}$ $\Omega$cm, a sheet resistance Rs=48 $\Omega/\square$, a carrier concentration=$7.04 \times 10^{20}$ cm$^{-3}$, and $\mu$=10.4 cm$^2$/Vs.
As shown by the results in Fig. 7, when the amorphous layer having a Nb content of 4 atomic% is annealed in the atmosphere at 350°C, the electric conductivity deteriorates. Whereas, with the substrate in this Example, the atmospheric annealing was carried out in a state wherein an amorphous layer having a Nb content of 1 atomic% was laminated on an amorphous layer having a Nb content of 4 atomic%, the electric conductivity did not deteriorate even when heated at 350°C, and an electric conductor film having a low resistance was obtained.

WORKING EXAMPLE 3

This Example is an Example wherein the precursor layers were prepared by a sputtering method.
In the following Example of the sputtering method, "room temperature" for the substrate temperature is within a range of from 25°C to 80°C. In this Example, film forming was carried out by a sputtering method under such condition that the substrate was not heated, and it was confirmed that the substrate temperature at that time was within a range of from 70°C to 80°C.
Using a reactive DC magnetron sputtering device, an amorphous layer was formed on a substrate under the film forming conditions. As the substrate, a non-alkali glass having a thickness of 1 mm, model name: AN100, manufactured by Asahi Glass Company, Limited) was used. That is, in a vacuum tank of the reactive DC magnetron sputtering device, a Ti-Nb alloy was set as the target, and the substrate was set.

The distance (T/S) between the target and the substrate was adjusted to be 70 mm. Then, the vacuum tank was evacuated by a pump to at most $5 \times 10^{-4}$ Pa, and then Ar gas and $O_2$ gas were introduced into the vacuum system so that the ratio of $O_2/(Ar+O_2)$ would be 7.5 vol%, and the pressure in the vacuum tank was adjusted to 1.0 Pa.

And, in a state of a magnetron magnetic field intensity of 1000 G, a voltage with 150 W was applied to the Ti-Nb alloy target to form a titanium oxide film (precursor layer) doped with Nb on the substrate. Without heating the substrate, the substrate temperature was at room temperature. The thickness of the obtained amorphous layer (precursor layer) was 150 nm.

Amorphous layers having a Nb content of from 0 to 15 atomic% were formed by changing the target composition, and the relation between the crystallization temperature Tcr and the amount of dopant was measured in the same manner as in Example 2, whereby the results substantially equivalent to Fig. 7 were obtained.

Separately, the relation between the Nb content (atomic%) and the electric conductivity-deteriorating temperature Td (°C) was measured in the same manner as in Example 3, whereby the results substantially equal to Fig. 7 were obtained.

Then, an electric conductor having a structure shown in Fig. 4 was formed.

That is, an amorphous layer (precursor layer) was formed in the same manner under the above sputtering conditions except that a Ti-Nb alloy containing from 0.01 to 4 atomic% of Nb was used as the target, and the film thickness was 150 nm and then annealed in the atmosphere to form a transparent conductor film. The annealing temperature was 350°C. It took three minutes until the substrate temperature reached the annealing temperature from room temperature. The temperature was maintained at the predetermined annealing temperature for one hour and then left to cool to room temperature. The obtained transparent electric conductor film had a thickness of 150 nm and a specific resistance of $1.1 \times 10^{-3}$ Ωcm.

WORKING EXAMPLE 4

An electric conductor having a structure shown in Fig. 2 is formed by a sputtering method.

(FILM FORMING CONDITION 1)

Using a reactive DC magnetron sputtering apparatus, a titanium oxide film doped with Nb is formed on a substrate. As the substrate, a non-alkali glass having a thickness of 1 mm (model name: AN100, manufactured by Asahi Glass Company, Limited) is used. As the sputtering gas, a mixed gas of Ar gas and $O_2$ gas is used.

That is, in a vacuum tank of the reactive DC magnetron sputtering apparatus, a titanium oxide sintered body containing 1 atomic% of Nb is set as a metal oxide target, and the substrate is also set.

Then, the vacuum tank is evacuated by a pump to at most $5 \times 10^{-4}$ Pa, and then Ar gas and $O_2$ gas are introduced into the vacuum system so that the $O_2$ flow ratio represented by $O_2/(Ar+O_2)$ (oxidizing sputtering gas flow ratio) will be 1.0 vol%, and the pressure in the vacuum tank (sputtering pressure) is adjusted to be 1.0 Pa.

And, in a state where a predetermined magnetic field is applied to the target, a power of 150 W is applied to the metal oxide target to form a titanium oxide film doped with Nb on the substrate. Without heating the substrate, the substrate temperature is at room temperature. The film thickness is adjusted to be 100 nm.

Then, a single layer annealing test is carried out to obtain a sample having an electric conductor layer formed on the substrate. The Nb content of the obtained electric conductor layer becomes 1 atomic%.

By an XRD profile, it is confirmed that the film is an amorphous state before the annealing.

The electric conductor layer after the annealing is subjected to an X-ray diffraction, whereby a (101) peak and a (004) peak attributable to anatase crystals are observed, and a (110) peak attributable to rutile crystals is not observed.

Accordingly, it is observed that before the annealing, the layer is an amorphous layer, and after the single layer annealing test, it becomes a layer containing polycrystals, and such polycrystals contain no rutile crystals. That is, the above condition (X1) is satisfied.

(FILM FORMING CONDITION 2)

A titanium oxide film doped with Nb is formed on a substrate in the same manner under the above film forming condition 1 except that the $O_2$ flow ratio (oxidizing sputtering gas flow ratio) is changed to 0 vol%, and the metal oxide target is changed to a titanium oxide sintered body containing 4 atomic% of Nb.

Then, a single layer annealing test is carried out to obtain a sample having an electric conductor layer formed on the substrate. The Nb content in the obtainable electric conductor layer becomes 4 atomic%.

By an XRD profile, it is confirmed that before the annealing, the film is an amorphous state.

The electric conductor layer after the annealing is subjected to X-ray diffraction, whereby no (101) or (004) peak is observed, and a (110) peak is observed.

Accordingly, it is confirmed that before the annealing, the layer is an amorphous layer, and after the single layer annealing test, it becomes a layer containing polycrystals, and such polycrystals contain rutile crystals. That is, the above condition (Y1) is satisfied.

A precursor layer for the seed layer is formed on a substrate in the same manner under the film forming condition 1 except that the film thickness is changed to 30 nm.

Then, a precursor layer for the interlayer is formed thereon in the same manner under the above film forming condition 2 except that the film thickness is changed to 120 nm.

Then, a precursor layer for the protective layer on the substrate is formed thereon in the same manner under the film forming condition 1 except that the film thickness is changed to 30 nm.

A laminate thus obtained is subjected to annealing in the atmosphere to obtain an electric conductor. The annealing temperature is set at 325°C by predicting the crystallization temperature Tcr and electric conductivity-deteriorating temperature Td of each precursor layer based on the graph in Fig. 7. It takes three minutes till the substrate temperature reaches the annealing temperature from room temperature. The temperature is maintained at the predetermined annealing temperature for one hour, and then left to cool to room temperature. The obtainable transparent electric conductor film has a film thickness of 180 nm and a specific resistance of $9.5 \times 10^{-4}$ $\Omega$cm.

INDUSTRIAL APPLICABILITY

The electric conductor of the present invention has good electric conductivity and transparency and can be used as a transparent electrically conductive thin film which is excellent in heat resistance and which has a high visible light transmittance and a low resistance, and it is useful as transparent electrodes for flat panel displays, solar cells, touch panels, etc.

**Claims**

1. An electric conductor comprising a substrate and at least two layers formed on the substrate, each being a layer (Z) made of titanium oxide doped with at least one dopant selected from the group consisting of Nb, Ta, Mo, As, Sb, W, N, F, S, Se, Te, Cr, Ni, Tc, Re, P and Bi, wherein:

   at least one layer among said at least two layers is a second layer (Z2) wherein the percentage of the number of dopant atoms based on the total number of titanium and dopant atoms is from 0.01 to 4 atomic%; and
   between the second layer (Z2) and the substrate, a first layer (Z1) is formed

   wherein the percentage of the number of dopant atoms based on the total number of titanium and dopant atoms is larger than in the second layer (Z2).

2. The electric conductor according to Claim 1, wherein in the first layer (Z1), the percentage of the number of dopant atoms based on the total number of titanium and dopant atoms is from 2 to 7 atomic%.

3. The electric conductor according to Claim 1 or 2, wherein the second layer (Z2) has a thickness of at least 3nm.

4. The electric conductor according to any one of Claims 1 to 3, wherein the substrate is made of glass.

5. The electric conductor according to any one of Claims 1 to 4, wherein the dopant is Nb or Ta.

6. A process for producing an electric conductor, which comprises:

   a precursor layer-forming step of forming on a substrate a precursor layer made of titanium oxide doped with at least one dopant selected from the group consisting of Nb, Ta, Mo, As, Sb, W, N, F, S, Se, Te, Cr, Ni, Tc, Re, P and Bi, wherein the percentage of the number of dopant atoms based on the total number of titanium and dopant atoms is from 0.01 to 4 atomic%; and
   an atmospheric annealing step of heat-treating the precursor layer in the atmosphere in a temperature range of at least the crystallization temperature and lower than the electric conductivity-deteriorating temperature of the precursor layer.

7. A process for producing an electric conductor, which comprises:

   a precursor layer-forming step of forming on a substrate at least two precursor layers each being a layer made of titanium oxide doped with at least one dopant selected from the group consisting of Nb, Ta, Mo, As, Sb, W, N, F, S, Se, Te, Cr, Ni, Tc, Re, P and Bi; and
   an atmospheric annealing step of heat-treating the precursor layers in the atmosphere; wherein:

   at least one layer among said at least two precursor layers is a second precursor layer wherein the percentage of the number of dopant atoms based on the total number of titanium and dopant atoms is from 0.01 to 4 atomic%;
   between the second precursor layer and the substrate, a first precursor layer is present wherein the percentage of the number of dopant atoms based on the total number of titanium and dopant atoms is larger than in the second dopant layer; and
   the heat-treating temperature in the atmospheric annealing step is at least the highest temperature among the respective crystallization temperatures of the precursor layers formed on the substrate and lower than the electric conductivity-deteriorating temperature of the second precursor layer.

8. The process for producing an electric conductor according to Claim 7, wherein at least one layer among said at least two precursor layers, when subjected to a single layer annealing test, becomes a layer containing polycrystals which contain no rutile crystals.

9. The process for producing an electric conductor according to any one of Claims 6 to 8, wherein forming of the precursor layer(s) is carried out by a pulsed laser deposition method or a sputtering method.

10. The process for producing an electric conductor according to any one of Claims 6 to 9, wherein the substrate is made of glass.


**Patentansprüche**

1. Elektrischer Leiter, welcher ein Substrat und mindestens zwei Schichten, die auf dem Substrat gebildet sind, umfasst, wovon jede eine Schicht (Z), hergestellt aus Titanoxid, dotiert mit mindestens einem Dotiermittel, ausgewählt aus der Gruppe, bestehend aus Nb, Ta, Mo, As, Sb, W, N, F, S, Se, Te, Cr, Ni, Tc, Re, P und Bi, ist, wobei mindestens eine Schicht der mindestens zwei Schichten eine zweite Schicht (Z2) ist, worin der prozentuale Anteil der Anzahl der Dotiermittelatome, bezogen auf die Gesamtzahl der Titan- und Dotiermittelatome, 0,01 bis 4 Atom-% beträgt, und zwischen der zweiten Schicht (Z2) und dem Substrat eine erste Schicht (Z1) gebildet ist, worin der prozentuale Anteil der Anzahl der Dotiermittelatome, bezogen auf die Gesamtzahl der Titan- und Dotiermittelatome, größer als in der zweiten Schicht (Z2) ist.

2. Elektrischer Leiter nach Anspruch 1, wobei in der ersten Schicht (Z1) der prozentuale Anteil der Anzahl der Dotiermittelatome, bezogen auf die Gesamtzahl der Titan- und Dotiermittelatome, 2 bis 7 Atom-% beträgt.

3. Elektrischer Leiter nach Anspruch 1 oder 2, wobei die zweite Schicht (Z2) eine Dicke von mindestens 3 nm aufweist.

4. Elektrischer Leiter nach einem der Ansprüche 1 bis 3, wobei das Substrat aus Glas hergestellt ist.

5. Elektrischer Leiter nach einem der Ansprüche 1 bis 4, wobei das Dotiermittel Nb oder Ta ist.

6. Verfahren zur Herstellung eines elektrischen Leiters, umfassend einen Vorläuferschicht-Bildungsschritt des Bildens einer Vorläuferschicht, hergestellt aus Titanoxid, dotiert mit mindestens einem Dotiermittel, ausgewählt aus der Gruppe, bestehend aus Nb, Ta, Mo, As, Sb, W, N, F, S, Se, Te, Cr, Ni, Tc, Re, P und Bi, auf einem Substrat, worin der prozentuale Anteil der Anzahl der Dotiermittelatome, bezogen auf die Gesamtzahl der Titan- und Dotiermittelatome, 0,01 bis 4 Atom-% beträgt, einen atmosphärischen Temperschritt des Wärmebehandelns der Vorläuferschicht in der Atmosphäre in einem Temperaturbereich von mindestens der Kristallisationstemperatur und niedriger als der Elektrische-Leitfähigkeit-Verschlechterungs-Temperatur der Vorläuferschicht.

7. Verfahren zur Herstellung eines elektrischen Leiters, umfassend einen Vorläuferschicht-Bildungsschritt des Bildens von mindestens zwei Vorläuferschichten, von denen jede eine Schicht, hergestellt aus Titanoxid, dotiert mit mindestens einem Dotiermittel, ausgewählt aus der Gruppe, bestehend aus Nb, Ta, Mo, As, Sb, W, N, F, S, Se, Te, Cr, Ni, Tc, Re, P und Bi, ist, auf einem Substrat und einen atmosphärischen Temperschritt des Wärmebehandelns der Vorläuferschichten in der Atmosphäre, wobei mindestens eine Schicht der mindestens zwei Vorläuferschichten eine zweite Vorläuferschicht ist, worin der prozentuale Anteil der Anzahl der Dotiermittelatome, bezogen auf die Gesamtanzahl von Titan- und Dotiermittelatomen, 0,01 bis 4 Atom-% beträgt, zwischen der zweiten Vorläuferschicht und dem Substrat eine erste Vorläuferschicht vorhanden ist, worin der prozentuale Anteil der Anzahl der Dotiermittelatome, bezogen auf die Gesamtzahl der Titan- und Dotiermittelatome, größer als in der zweiten Dotiermittelschicht ist und die Wärmebehandlungstemperatur in dem atmosphärischen Temperschritt mindestens die höchste Temperatur der jeweiligen Kristallisationstemperaturen der Vorläuferschichten, die auf dem Substrat gebildet sind, und niedriger als die Elektrische-Leitfähigkeit-Verschlechterungs-Temperatur der zweiten Vorläuferschicht ist.

8. Verfahren zur Herstellung eines elektrischen Leiters nach Anspruch 7, wobei mindestens eine Schicht der mindestens zwei Vorläuferschichten, wenn einem Einzelschicht-Tempertest unterzogen, zu einer Schicht, enthaltend Polykristalle, die keine Rutil-Kristalle enthalten, wird.

9. Verfahren zur Herstellung eines elektrischen Leiters nach einem der Ansprüche 6 bis 8, worin das Bilden der Vorläuferschicht(en) durch ein Abscheideverfahren mit gepulstem Laser oder ein Sputterverfahren durchgeführt wird.

10. Verfahren zur Herstellung eines elektrischen Leiters nach einem der Ansprüche 6 bis 9, wobei das Substrat aus Glas hergestellt ist.

**Revendications**

1. Conducteur électrique comprenant un substrat et au moins deux couches formées sur le substrat, chacune étant une couche (Z) faite en oxyde de titane dopé avec au moins un dopant choisi dans l'ensemble constitué par Nb, Ta, Mo, As, Sb, W, N, F, S, Se, Te, Cr, Ni, Tc, Re, P et Bi, dans lequel :

   au moins une couche parmi lesdites au moins deux couches est une deuxième couche (Z2) dans laquelle le pourcentage du nombre d'atomes dopants par rapport au nombre total d'atomes de titane et de dopant est de 0,01 à 4 % atomiques ; et
   entre la deuxième couche (Z2) et le substrat, est formée une première couche (Z1) dans laquelle le pourcentage du nombre d'atomes dopants par rapport au nombre total d'atomes de titane et dé dopant est supérieur à celui de la deuxième couche (Z2).

2. Conducteur électrique selon la revendication 1, dans lequel, dans la première couche (Z1), le pourcentage du nombre d'atomes dopants par rapport au nombre total d'atomes de titane et de dopant est de 2 à 7 % atomiques.

3. Conducteur électrique selon la revendication 1 ou 2, dans lequel la deuxième couche (Z2) présente une épaisseur d'au moins 3 nm.

4. Conducteur électrique selon l'une quelconque des revendications 1 à 3, dans lequel le substrat est fait en verre.

5. Conducteur électrique selon l'une quelconque des revendications 1 à 4, dans lequel le dopant est Nb ou Ta.

6. Procédé pour produire un conducteur électrique, qui comprend :

   une étape de formation de couche de précurseur, consistant à former sur un substrat une couche de précurseur faite en oxyde de titane dopé avec au moins un dopant choisi dans l'ensemble constitué par Nb, Ta, Mo, As, Sb, W, N, F, S, Se, Te, Cr, Ni, Tc, Re, P et Bi, dans laquelle le pourcentage du nombre d'atomes dopants par rapport au nombre total d'atomes de titane et de dopant est de 0,01 à 4 % atomiques ; et une étape de recuit atmosphérique consistant à traiter à la chaleur la couche de précurseur dans l'atmosphère, à une température située dans la plage d'au moins la température de cristallisation et inférieure à la température de détérioration de la conductivité électrique de la couche de précurseur.

7. Procédé pour produire un conducteur électrique, qui comprend :

   une étape de formation de couches de précurseur, consistant à former sur un substrat au moins deux couches de précurseur qui sont chacune une couche faite en oxyde de titane dopé avec au moins un dopant choisi dans l'ensemble constitué par Nb, Ta, Mo, As, Sb, W, N, F, S, Se, Te, Cr, Ni, Tc, Re, P et Bi, et
   une étape de recuit atmosphérique consistant à traiter à la chaleur les couches de précurseur dans l'atmosphère, et dans lequel :

   au moins une couche parmi lesdites au moins deux couches de précurseur est une deuxième couche de précurseur dans laquelle le pourcentage du nombre d'atomes dopants par rapport au nombre total d'atomes de titane et de dopant est de 0,01 à 4 % atomiques ;
   entre la deuxième couche de précurseur et le substrat, est présente une première couche de précurseur dans laquelle le pourcentage du nombre d'atomes dopants par rapport au nombre total d'atomes de titane et de dopant est supérieur à celui de la deuxième couche de dopant ; et
   la température de traitement à la chaleur dans l'étape de recuit atmosphérique est au moins la température la plus élevée parmi les températures de cristallisation respectives des couches de précurseur formées sur le substrat, et est inférieure à la température de détérioration de la conductivité électrique de la deuxième couche de précurseur.

8. Procédé pour produire un conducteur électrique selon la revendication 7, dans lequel au moins une couche parmi lesdites au moins deux couches de précurseur, lorsqu'elle est soumise à un test de recuit de couche isolée, devient une couche contenant des polycristaux qui ne contiennent pas de cristaux rutiles.

**9.** Procédé pour produire un conducteur électrique selon l'une quelconque des revendications 6 à 8, dans lequel la formation de la ou des couche(s) de précurseur est effectuée par un procédé de déposition à laser pulsé ou un procédé de pulvérisation cathodique.

**10.** Procédé pour produire un conducteur électrique selon l'une quelconque des revendications 6 à 9, dans lequel le substrat est fait en verre.

**Fig. 1**

T2
T1

12
11
10

**Fig. 2**

T1b
T1a

12
11b
11a
10

**Fig. 3 (a)**

**Fig. 3 (b)**

**Fig. 4**

## Fig. 5

Specific resistance ρ (Ωcm) vs Substrate temperature (°C)

## Fig. 6

| dρ/dT | vs Substrate temperature (°C)

## Fig. 7

Film forming oxygen partial pressure $1 \times 10^{-3}$ Torr

**Fig. 8**

** Film forming oxygen partial pressure $1 \times 10^{-3}$ Torr

**Fig. 9**

## Fig. 10

**Fig. 11**

**Fig. 12**

**Fig. 13**

**Fig. 14**

# Fig. 15

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006016608 A
- JP 2004095240 A
- JP 2008084824 A
- US 20070218646 A
- US 688013 A

**Non-patent literature cited in the description**

- *Oyo Butsuri,* 2004, vol. 73 (5), 587-592